(19) **Europäisches Patentamt / European Patent Office / Office européen des brevets**

(11) **EP 1 803 117 B1**

(12) **EUROPEAN PATENT SPECIFICATION**

(45) Date of publication and mention
of the grant of the patent:
**04.03.2009 Bulletin 2009/10**

(21) Application number: **05792350.0**

(22) Date of filing: **07.09.2005**

(51) Int Cl.:
*G10L 19/02* [(2006.01)]   *G10L 19/00* [(2006.01)]

(86) International application number:
**PCT/EP2005/009618**

(87) International publication number:
**WO 2006/045371 (04.05.2006 Gazette 2006/18)**

(54) **INDIVIDUAL CHANNEL TEMPORAL ENVELOPE SHAPING FOR BINAURAL CUE CODING SCHEMES AND THE LIKE**

INDIVIDUELLE KANALTEMPORÄRE ENVELOPPENFORMUNG FÜR BINAURALE HINWEISCODIERUNGSVERFAHREN UND DERGLEICHEN

MISE EN FORME DE L'ENVELOPPE TEMPORELLE DE CANAUX INDIVIDUELS POUR DES SCHEMAS DE CODAGE REPERE BIAURICULAIRE ANALOGUES

(84) Designated Contracting States:
**AT BE BG CH CY CZ DE DK EE ES FI FR GB GR HU IE IS IT LI LT LU LV MC NL PL PT RO SE SI SK TR**

(30) Priority: **20.10.2004 US 620480 P**
**07.12.2004 US 6482**

(43) Date of publication of application:
**04.07.2007 Bulletin 2007/27**

(73) Proprietors:
• **Fraunhofer-Gesellschaft zur Förderung der angewandten Forschung e.V.
80686 München (DE)**
• **Agere Systems, Inc.
Allentown, PA 18109 (US)**

(72) Inventors:
• **ALLAMANCHE, Eric
Sunnyvale, CA 94087 (US)**
• **DISCH, Sascha
90763 Fuerth (DE)**
• **FALLER, Christof
CH-8274 Taegerwilen (CH)**
• **HERRE, Juergen
91054 Buckenhof (DE)**

(74) Representative: **Schoppe, Fritz et al
Schoppe, Zimmermann,
Stöckeler & Zinkler
Patentanwälte
Postfach 246
D-82043 Pullach bei München (DE)**

(56) References cited:
**US-A- 5 812 971      US-A1- 2003 187 663
US-B1- 6 539 357**

• HERRE, J. ET AL.: "The Reference Model Architecture for MPEG Spatial Audio Coding" AUDIO ENGINEERING SOCIETY CONVENTION PAPER 6447, PRESENTED AT THE 118TH CONVENTION, 29 May 2005 (2005-05-29), pages 1-13, XP009059973 Barcelona, Spain
• SCHUIJERS, E. ET AL.: "ADVANCES IN PARAMETRIC CODING FOR HIGH-QUALITY AUDIO" AUDIO ENGINEERING SOCIETY CONVENTION PAPER 5852, PRESENTED AT THE 114TH CONVENTION, 22 March 2003 (2003-03-22), pages 1-11, XP008021606 Amsterdam, The Netherlands cited in the application
• JÜRGEN HERRE: "FROM JOINT STEREO TO SPATIAL AUDIO CODING - RECENT PROGRESS AND STANDARIZATION" PROC. OF THE 7TH INT. CONFERENCE ON DIGITAL AUDIO EFFECTS (DAFX'O4), 5 October 2004 (2004-10-05), XP002367849 Naples, Italy
• CHRISTOF FALLER: "PARAMETRIC CODING OF SPATIAL AUDIO" PROC. OF THE 7TH INT. CONFERENCE ON DIGITAL AUDIO EFFECTS (DAFX'O4), 5 October 2004 (2004-10-05), XP002367850 Naples, Italy cited in the application

**Description**

BACKGROUND OF THE INVENTION

The subject matter of this application is related to the subject matter of the following U.S. application publications;

o U.S. 2003/0026441;
o U.S. 2003/0035553;
o U.S. 2003/0219130;
o U.S. 2003/0236583;
o U.S. 2009/0180579;
o U.S. 2005/0058304;
o U.S. 2005/0157883; and
o U.S. 2006/0085200.

The subject matter of this application is also related to subject matter described in the following papers:

o F. Baumgarte and C. Faller, "Binaural Cue Coding - Part I: Psychoacoustic fundamentals and design principles," IEEE Trans. on Speech and Audio Proc., vol. 11, no. 6, Nov. 2003;
o C. Faller and F. Baumgarte, "Binaural Cue Coding - Part II: Schemes and applications," IEEE Trans. on Speech and Audio Proc., vol. 11, no. 6, Nov. 2003; and
o C. Faller, "Coding of spatial audio compatible with different playback formats," Preprint 17th Conv. Aud. Eng. Soc., October 2004.

Field of the Invention

The present invention relates to the encoding of audio signals and the subsequent synthesis of auditory scenes from the encoded audio data.

Description of the Related Art

When a person hears an audio signal (i.e., sounds) generated by a particular audio source, the audio signal will typically arrive at the person's left and right ears at two different times and with two different audio (e.g., decibel) levels, where those different times and levels are functions of the differences in the paths through which the audio signal travels to reach the left and right ears, respectively. The person's brain interprets these differences in time and level to give the person the perception that the received audio signal is being generated by an audio source located at a particular position (e.g., direction and distance) relative to the person. An auditory scene is the net effect of a person simultaneously hearing audio signals generated by one or more different audio sources located at one or more different positions relative to the person.

The existence of this processing by the brain can be used to synthesize auditory scenes, where audio signals from one or more different audio sources are purposefully modified to generate left and right audio signals that give the perception that the different audio sources are located at different positions relative to the listener.

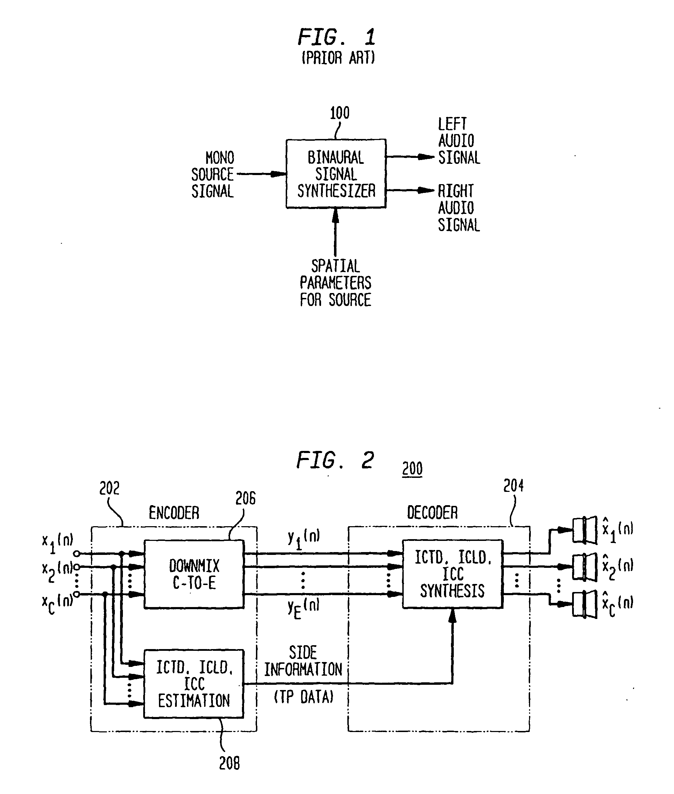

Fig. 1 shows a high-level block diagram of conventional binaural signal synthesizer 100, which converts a single audio source signal (e.g., a mono signal) into the left and right audio signals of a binaural signal, where a binaural signal is defined to be the two signals received at the eardrums of a listener. In addition to the audio source signal, synthesizer 100 receives a set of spatial cues corresponding to the desired position of the audio source relative to the listener. In typical implementations, the set of spatial cues comprises an inter-channel level difference (ICLD) value (which identifies the difference in audio level between the left and right audio signals as received at the left and right ears, respectively) and an inter-channel time difference (ICTD) value (which identifies the difference in time of arrival between the left and right audio signals as received at the left and right ears, respectively). In addition or as an alternative, some synthesis techniques involve the modeling of a direction-dependent transfer function for sound from the signal source to the eardrums, also referred to as the head-related transfer function (HRTF). See, e.g., J. Blauert, The Psychophysics of Human Sound Localization, MIT Press, 1983.

Using binaural signal synthesizer 100 of Fig. 1, the mono audio signal generated by a single sound source can be processed such that, when listened to over headphones, the sound source is spatially placed by applying an appropriate set of spatial cues (e.g., ICLD, ICTD, and/or HRTF) to generate the signal for each ear. See, e.g., D.R. Begault, 3-D Sound for Virtual Reality and Multimedia, Academic Press, Cambridge, MA, 1994.

Binaural signal synthesizer **100** of Fig. 1 generates the simplest type of auditory scenes: those having a single audio source positioned relative to the listener. More complex auditory scenes comprising two or more audio sources located at different positions relative to the listener can be generated using an auditory scene synthesizer that is essentially implemented using multiple instances of binaural signal synthesizer, where each binaural signal synthesizer instance generates the binaural signal corresponding to a different audio source. Since each different audio source has a different location relative to the listener, a different set of spatial cues is used to generate the binaural audio signal for each different audio source.

It is an object of the present invention to provide an improved concept for audio coding.

This object is achieved by a method for encoding of claim 1, an apparatus for encoding of claim 14, a computer program product of claim 17, an encoded audio bitstream of claim 18, a method for decoding of claim 20, an apparatus for decoding of claim 39, and a computer program product of claim 41. Document US 5,812, 971 (HERRE) discloses an intensity stereo coding method of multi-channel audio signals using temporal envelope shaping.

AES Convention Paper 6447, J. Herre et. al, "The Reference Model Architecture for MPEG Spatial Audio Coding", discloses a way, in which one does not have a fully discrete representation of multi-channel sound, but one has a stereo compatible transmission rate only slightly higher than rates commonly used for mono/stereo sound. Specifically, OTT elements and TTT elements are used, which are based on level differences parameters and inter-channel coherents/cross correlation parameters representing the time/frequency-variant coherence or cross-correlation between two input channels.

The technical publication "Parametric Coding of Spatial Audio", C. Faller, Proceedings of the 7th International Conference on Digital Audio Effect, Naples, Italy, October 5, 2004 pages 151 to 156 discloses the BCC technology. BCC represents stereo or multi-channel audio signals as a single or more down mixed audio channels plus side information. The side information contains the interchannel cues inherent in the original audio signal that are relevant for the perception of properties of the auditory spatial image. The relation between the inter-channel cues and attributes of the audio auditory spatial image is discussed.

BRIEF DESCRIPTION OF THE DRAWINGS

Other aspects, features, and advantages of the present invention will become more fully apparent from the following detailed description, the appended claims, and the accompanying drawings in which like reference numerals identify similar or identical elements.

Fig. 1 shows a high-level block diagram of conventional binaural signal synthesizer;

Fig. 2 is a block diagram of a generic binaural cue coding (BCC) audio processing system;

Fig. 3 shows a block diagram of a downmixer that can be used for the downmixer of Fig. 2;

Fig. 4 shows a block diagram of a BCC synthesizer that can be used for the decoder of Fig. 2;

Fig. 5 shows a block diagram of the BCC estimator of Fig. 2, according to one embodiment of the present invention;

Fig. 6 illustrates the generation of ICTD and ICLD data for five-channel audio;

Fig. 7 illustrates the generation of ICC data for five-channel audio;

Fig. 8 shows a block diagram of an implementation of the BCC synthesizer of Fig. 4 that can be used in a BCC decoder to generate a stereo or multi-channel audio signal given a single transmitted sum signal $s(n)$ plus the spatial cues;

Fig. 9 illustrates how ICTD and ICLD are varied within a subband as a function of frequency;

Fig. 10 shows a block diagram of time-domain processing that is added to a BCC encoder, such as the encoder of Fig. 2, according to one embodiment of the present invention;

Fig. 11 illustrates an exemplary time-domain application of TP processing in the context of the BCC synthesizer of Fig. 4;

Fig. 13 shows a block diagram of frequency-domain processing that is added to a BCC encoder, such as the encoder of Fig. 2, according to an alternative embodiment of the present invention;

Fig. 14 illustrates an exemplary frequency-domain application of TP processing in the context of the BCC synthesizer of Fig. 4;

Fig. 15 shows a block diagram of frequency-domain processing that is added to a BCC encoder, such as the encoder of Fig. 2, according to another alternative embodiment of the present invention;

Fig. 16 illustrates another exemplary frequency-domain application of TP processing in the context of the BCC synthesizer of Fig. 4;

Figs. 17(a)-(c) show block diagrams of possible implementations of the TPAs of Figs. 15 and 16 and the ITP and TP of Fig. 16; and

Figs. 18(a) and (b) illustrate two exemplary modes of operating the control block of Fig. 16.

DETAILED DESCRIPTION

In binaural cue coding (BCC), an encoder encodes $C$ input audio channels to generate $E$ transmitted audio channels, where $C>E\geq1$. In particular, two or more of the $C$ input channels are provided in a frequency domain, and one or more cue codes are generated for each of one or more different frequency bands in the two or more input channels in the frequency domain. In addition, the $C$ input channels are downmixed to generate the $E$ transmitted channels. In some downmixing implementations, at least one of the $E$ transmitted channels is based on two or more of the $C$ input channels, and at least one of the E transmitted channels is based on only a single one of the $C$ input channels.

In one embodiment, a BCC coder has two or more filter banks, a code estimator, and a downmixer. The two or more filter banks convert two or more of the $C$ input channels from a time domain into a frequency domain. The code estimator generates one or more cue codes for each of one or more different frequency bands in the two or more converted input channels. The downmixer downmixes the $C$ inputs channels to generate the $E$ transmitted channels, where $C>E\geq1$.

In BCC decoding, $E$ transmitted audio channels are decoded to generate $C$ playback audio channels. In particular, for each of one or more different frequency bands, one or more of the E transmitted channels are upmixed in a frequency domain to generate two or more of the $C$ playback channels in the frequency domain, where $C>E\geq1$. One or more cue codes are applied to each of the one or more different frequency bands in the two or more playback channels in the frequency domain to generate two or more modified channels, and the two or more modified channels are converted from the frequency domain into a time domain. In some upmixing implementations, at least one of the $C$ playback channels is based on at least one of the $E$ transmitted channels and at least one cue code, and at least one of the $C$ playback channels is based on only a single one of the E transmitted channels and independent of any cue codes.

In one embodiment, a BCC decoder has an upmixer, a synthesizer, and one or more inverse filter banks. For each of one or more different frequency bands, the upmixer upmixes one or more of the $E$ transmitted channels in a frequency domain to generate two or more of the $C$ playback channels in the frequency domain, where $C>E\geq1$. The synthesizer applies one or more cue codes to each of the one or more different frequency bands in the two or more playback channels in the frequency domain to generate two or more modified channels. The one or more inverse filter banks convert the two or more modified channels from the frequency domain into a time domain.

Depending on the particular implementation, a given playback channel may be based on a single transmitted channel, rather than a combination of two or more transmitted channels. For example, when there is only one transmitted channel, each of the $C$ playback channels is based on that one transmitted channel. In these situations, upmixing corresponds to copying of the corresponding transmitted channel. As such, for applications in which there is only one transmitted channel, the upmixer may be implemented using a replicator that copies the transmitted:channel for each playback channel.

BCC encoders and/or decoders may be incorporated into a number of systems or applications including, for example, digital video recorders/players, digital audio recorders/players, computers, satellite transmitters/receivers, cable transmitters/receivers, terrestrial broadcast transmitters/receivers, home entertainment systems, and movie theater systems.

Generic BCC Processing

Fig. 2 is a block diagram of a generic binaural cue coding (BCC) audio processing system **200** comprising an encoder **202** and a decoder **204.** Encoder 202 includes downmixer **206** and BCC estimator **208.**

Downmixer 206 converts $C$ input audio channels $x_i(n)$ into E transmitted audio channels $y_i(n)$, where $C>E\geq1$. In this specification, signals expressed using the variable $n$ are time-domain signals, while signals expressed using the variable k are frequency-domain signals. Depending on the particular implementation, downmixing can be implemented in either the time domain or the frequency domain. BCC estimator 208 generates BCC codes from the $C$ input audio channels and transmits those BCC codes as either in-band or out-of band side information relative to the E transmitted audio channels. Typical BCC codes include one or more of inter-channel time difference (ICTD), inter-channel level difference (ICLD), and inter-channel correlation (ICC) data estimated between certain pairs of input channels as a function of frequency and time. The particular implementation will dictate between which particular pairs of input channels, BCC codes are estimated. function of frequency and time. The particular implementation will dictate between which particular pairs of input channels, BCC codes are estimated.

ICC data corresponds to the coherence of a binaural signal, which is related to the perceived width of the audio source. The wider the audio source, the lower the coherence between the left and right channels of the resulting binaural signal. For example, the coherence of the binaural signal corresponding to an orchestra spread out over an auditorium stage is typically lower than the coherence of the binaural signal corresponding to a single violin playing solo. In general, an audio signal with lower coherence is usually perceived as more spread out in auditory space. As such, ICC data is typically related to the apparent source width and degree of listener envelopment. See, e.g., J. Blauert, The Psychophysics of Human Sound Localization, MIT Press, 1983.

Depending on the particular application, the *E* transmitted audio channels and corresponding BCC codes may be transmitted directly to decoder **204** or stored in some suitable type of storage device for subsequent access by decoder **204.** Depending on the situation, the term "transmitting" may refer to either direct transmission to a decoder or storage for subsequent provision to a decoder. In either case, decoder **204** receives the transmitted audio channels and side information and performs upmixing and BCC synthesis using the BCC codes to convert the *E* transmitted audio channels into more than *E* (typically, but not necessarily, *C*) playback audio channels $\hat{x}_i(n)$ for audio playback. Depending on the particular implementation, upmixing can be performed in either the time domain or the frequency domain.

In addition to the BCC processing shown in Fig. 2, a generic BCC audio processing system may include additional encoding and decoding stages to further compress the audio signals at the encoder and then decompress the audio signals at the decoder, respectively. These audio codecs may be based on conventional audio compression/decompression techniques such as those based on pulse code modulation (PCM), differential PCM (DPCM), or adaptive DPCM (ADPCM).

When downmixer **206** generates a single sum signal (i.e., *E*=1), BCC coding is able to represent multi-channel audio signals at a bitrate only slightly higher than what is required to represent a mono audio signal. This is so, because the estimated ICTD, ICLD, and ICC data between a channel pair contain about two orders of magnitude less information than an audio waveform.

Not only the low bitrate of BCC coding, but also its backwards compatibility aspect is of interest. A single transmitted sum signal corresponds to a mono downmix of the original stereo or multi-channel signal. For receivers that do not support stereo or multi-channel sound reproduction, listening to the transmitted sum signal is a valid method of presenting the audio material on low-profile mono reproduction equipment. BCC coding can therefore also be used to enhance existing services involving the delivery of mono audio material towards multi-channel audio. For example, existing mono audio radio broadcasting systems can be enhanced for stereo or multi-channel playback if the BCC side information can be embedded into the existing transmission channel. Analogous capabilities exist when downmixing multi-channel audio to two sum signals that correspond to stereo audio.

BCC processes audio signals with a certain time and frequency resolution. The frequency resolution used is largely motivated by the frequency resolution of the human auditory system. Psychoacoustics suggests that spatial perception is most likely based on a critical band representation of the acoustic input signal. This frequency resolution is considered by using an invertible filterbank (e.g., based on a fast Fourier transform (FFT) or a quadrature mirror filter (QMF)) with subbands with bandwidths equal or proportional to the critical bandwidth of the human auditory system.

Generic Downmixing

In preferred implementations, the transmitted sum signal(s) contain all signal components of the input audio signal. The goal is that each signal component is fully maintained. Simply summation of the audio input channels often results in amplification or attenuation of signal components. In other words, the power of the signal components in a "simple" sum is often larger or smaller than the sum of the power of the corresponding signal component of each channel. A downmixing technique can be used that equalizes the sum signal such that the power of signal components in the sum signal is approximately the same as the corresponding power in all input channels.

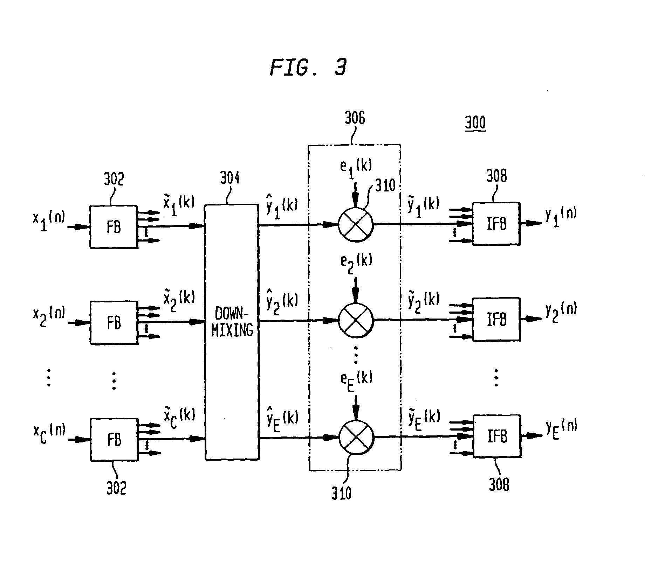

Fig. 3 shows a block diagram of a downmixer **300** that can be used for downmixer **206** of Fig. 2 according to certain implementations of BCC system **200**. Downmixer **300** has a filter bank (FB) **302** for each input channel $x_i(n)$, a downmixing block **304**, an optional scaling/delay block **306**, and an inverse FB (IFB) **308** for each encoded channel $y_i(n)$.

Each filter bank **302** converts each frame (e.g., 20 msec) of a corresponding digital input channel $x_i(n)$ in the time domain into a set of input coefficients $\tilde{x}_i(k)$ in the frequency domain. Downmixing block **304** downmixes each subband of *C* corresponding input coefficients into a corresponding sub-band of *E* downmixed frequency-domain coefficients. Equation (1) represents the downmixing of the kth subband of input coefficients $(\tilde{x}_1(k), \tilde{x}2(k), ... , \tilde{x}_c(k))$ to generate the kth sub-band of downmixed coefficients $(\hat{y}_1(k), \hat{y}_2(k), ..., \hat{y}_E(k))$ as follows:

$$
\begin{bmatrix} \hat{y}_1(k) \\ \hat{y}_2(k) \\ \vdots \\ \hat{y}_E(k) \end{bmatrix} = \mathbf{D}_{CE} \begin{bmatrix} \tilde{x}_1(k) \\ \tilde{x}_2(k) \\ \vdots \\ \tilde{x}_C(k) \end{bmatrix},
\tag{1}
$$

where $\mathbf{D}_{CE}$ is a real-valued *C*-by-*E* downmixing matrix.

Optional scaling/delay block **306** comprises a set of multipliers **310,** each of which multiplies a corresponding downmixed coefficient $\hat{y}_i(k)$ by a scaling factor $e_i(k)$ to generate a corresponding scaled coefficient $\tilde{y}_i(k)$. The motivation for the scaling operation is equivalent to equalization generalized for downmixing with arbitrary weighting factors for each channel. If the input channels are independent, then the power $P_{\tilde{y}i(k)}$ of the downmixed signal in each sub-band is given by Equation (2) as follows:

$$\begin{bmatrix} p_{\tilde{y}_1(k)} \\ p_{\tilde{y}_2(k)} \\ \vdots \\ p_{\tilde{y}_E(k)} \end{bmatrix} = \overline{\mathbf{D}}_{CE} \begin{bmatrix} p_{\tilde{x}_1(k)} \\ p_{\tilde{x}_2(k)} \\ \vdots \\ p_{\tilde{x}_C(k)} \end{bmatrix}, \qquad (2)$$

where $\overline{\mathbf{D}}_{CE}$ is derived by squaring each matrix element in the *C*-by-*E* downmixing matrix $\mathbf{D}_{CE}$ and $p_{\tilde{x}i(k)}$ is the power of sub-band *k* of input channel *i*.

If the sub-bands are not independent, then the power values $p_{\tilde{y}i\ (k)}$ of the downmixed signal will be larger or smaller than that computed using Equation (2), due to signal amplifications or cancellations when signal components are in-phase or out-of-phase, respectively. To prevent this, the downmixing operation of Equation (1) is applied in sub-bands followed by the scaling operation of multipliers **310.** The scaling factors $e_i(k)$ ($1 \le i \le E$) can be derived using Equation (3) as follows:

$$e_i(k) = \sqrt{\frac{p_{\tilde{y}_i(k)}}{p_{\hat{y}_i(k)}}}, \qquad (3)$$

where $p_{\tilde{y}i,\ (k)}$ is the sub-band power as computed by Equation (2), and $p_{\hat{y}i(k)}$ is power of the corresponding downmixed sub-band signal $\hat{y}_i(k)$.

In addition to or instead of providing optional scaling, scaling/delay block **306** may optionally apply delays to the signals.

Each inverse filter bank **308** converts a set of corresponding scaled coefficients $\tilde{y}_i\ (k)$ in the frequency domain into a frame of a corresponding digital, transmitted channel $y_i(n)$.

Although Fig. 3 shows all *C* of the input channels being converted into the frequency domain for subsequent downmixing, in alternative implementations, one or more (but less than *C*-1) of the *C* input channels might bypass some or all of the processing shown in Fig. 3 and be transmitted as an equivalent number of unmodified audio channels. Depending on the particular implementation, these unmodified audio channels might or might not be used by BCC estimator **208** of Fig. 2 in generating the transmitted BCC codes.

In an implementation of downmixer **300** that generates a single sum signal y(n), *E*=1 and the signals $\tilde{x}_c\ (k)$ of each subband of each input channel *c* are added and then multiplied with a factor e(k), according to Equation (4) as follows:

$$\tilde{y}(k) = e(k)\sum_{c=1}^{C} \tilde{x}_c(k). \qquad (4)$$

the factor *e(k)* is given by Equation (5) as follows:

$$e(k) = \sqrt{\frac{\sum_{c=1}^{C} p_{\widetilde{x}_c}(k)}{p_{\widetilde{x}}(k)}} \ , \tag{5}$$

where $p_{\widetilde{x}c}(k)$ is a short-time estimate of the power of $\widetilde{x}_c(k)$ at time index $k$, and $p_{\widetilde{x}}(k)$ is a short-time estimate of the power of $\sum_{c=1}^{C} \widetilde{x}_c(k)$. The equalized subbands are transformed back to the time domain resulting in the sum signal $y(n)$ that is transmitted to the BCC decoder.

Generic BCC Synthesis

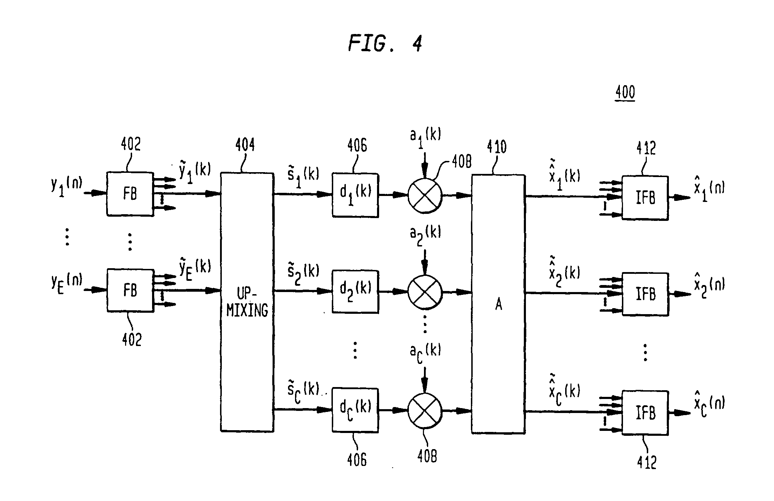

Fig. 4 shows a block diagram of a BCC synthesizer **400** that can be used for decoder **204** of Fig. 2 according to certain implementations of BCC system **200**. BCC synthesizer **400** has a filter bank **402** for each transmitted channel $y_i(n)$, an upmixing block **404,** delays **406,** multipliers **408,** correlation block **410,** and an inverse filter bank **412** for each playback channel $\overset{\wedge}{x}_i(n)$.

Each filter bank **402** converts each frame of a corresponding digital, transmitted channel $y_i(n)$ in the time domain into a set of input coefficients $\widetilde{y}_i(k)$ in the frequency domain. Upmixing block **404** upmixes each sub-band of $E$ corresponding transmitted-channel coefficients into a corresponding sub-band of $C$ upmixed frequency-domain coefficients. Equation (4) represents the upmixing of the $k$th sub-band of transmitted-channel coefficients $(\widetilde{y}_i(k), \widetilde{y}_2(k),...\widetilde{y}_E(k))$ to generate the kth sub-band of upmixed coefficients $(\widetilde{s}_i(k), \widetilde{s}_2(k), ... , \widetilde{s}_C(k))$ as follows:

$$\begin{bmatrix} \widetilde{s}_1(k) \\ \widetilde{s}_2(k) \\ \vdots \\ \widetilde{s}_C(k) \end{bmatrix} = \mathbf{U}_{EC} \begin{bmatrix} \widetilde{y}_1(k) \\ \widetilde{y}_2(k) \\ \vdots \\ \widetilde{y}_E(k) \end{bmatrix} , \tag{6}$$

where $\mathbf{U}_{EC}$ is a real-valued $E$-by-$C$ upmixing matrix. Performing upmixing in the frequency-domain enables upmixing to be applied individually in each different sub-band.

Each delay **406** applies a delay value $d_i(k)$ based on a corresponding BCC code for ICTD data to ensure that the desired ICTD values appear between certain pairs of playback channels. Each multiplier **408** applies a scaling factor $a_i(k)$ based on a corresponding BCC code for ICLD data to ensure that the desired ICLD values appear between certain pairs of playback channels. Correlation block **410** performs a decorrelation operation A based on corresponding BCC codes for ICC data to ensure that the desired ICC values appear between certain pairs of playback channels. Further description of the operations of correlation block 410 can be found in US 2003/0219130.

The synthesis of ICLD values may be less troublesome than the synthesis of ICTD and ICC values, since ICLD synthesis involves merely scaling of sub-band signals. Since ICLD cues are the most commonly used directional cues, it is usually more important that the ICLD values approximate those of the original audio signal. As such, ICLD data might be estimated between all channel pairs. The scaling factors $a_i(k)$ ($1 \le i \le C$) for each sub-band are preferably chosen such that the sub-band power of each playback channel approximates the corresponding power of the original input audio channel.

One goal may be to apply relatively few signal modifications for synthesizing ICTD and ICC values. As such, the BCC data might not include ICTD and ICC values for all channel pairs. In that case, BCC synthesizer **400** would synthesize ICTD and ICC values only between certain channel pairs.

Each inverse filter bank **412** converts a set of corresponding synthesized coefficients $\widetilde{\overset{\wedge}{x}}_i(k)$ in the frequency domain into a frame of a corresponding digital, playback channel $\overset{\wedge}{x}_i(n)$.

Although Fig. 4 shows all $E$ of the transmitted channels being converted into the frequency domain for subsequent upmixing and BCC processing, in alternative implementations, one or more (but not all) of the E transmitted channels might bypass some or all of the processing shown in Fig. 4. For example, one or more of the transmitted channels may be unmodified channels that are not subjected to any upmixing. In addition to being one or more of the *C* playback channels, these unmodified channels, in turn, might be, but do not have to be, used as reference channels to which BCC processing is applied to synthesize one or more of the other playback channels. In either case, such unmodified channels may be subjected to delays to compensate for the processing time involved in the upmixing and/or BCC processing used to generate the rest of the playback channels.

Note that, although Fig. 4 shows *C* playback channels being synthesized from *E* transmitted channels, where *C* was also the number of original input channels, BCC synthesis is not limited to that number of playback channels. In general, the number of playback channels can be any number of channels, including numbers greater than or less than *C* and possibly even situations where the number of playback channels is equal to or less than the number of transmitted channels.

"Perceptually relevant differences" between audio channels

Assuming a single sum signal, BCC synthesizes a stereo or multi-channel audio signal such that ICTD, ICLD, and ICC approximate the corresponding cues of the original audio signal. In the following, the role of ICTD, ICLD, and ICC in relation to auditory spatial image attributes is discussed.

Knowledge about spatial hearing implies that for one auditory event, ICTD and ICLD are related to perceived direction. When considering binaural room impulse responses (BRIRs) of one source, there is a relationship between width of the auditory event and listener envelopment and ICC data estimated for the early and late parts of the BRIRs. However, the relationship between ICC and these properties for general signals (and not just the BRIRs) is not straightforward.

Stereo and multi-channel audio signals usually contain a complex mix of concurrently active source signals superimposed by reflected signal components resulting from recording in enclosed spaces or added by the recording engineer for artificially creating a spatial impression. Different source signals and their reflections occupy different regions in the time-frequency plane. This is reflected by ICTD, ICLD, and ICC, which vary as a function of time and frequency. In this case, the relation between instantaneous ICTD, ICLD, and ICC and auditory event directions and spatial impression is not obvious. The strategy of certain embodiments of BCC is to blindly synthesize these cues such that they approximate the corresponding cues of the original audio signal.

Filterbanks with subbands of bandwidths equal to two times the equivalent rectangular bandwidth (ERB) are used. Informal listening reveals that the audio quality of BCC does not notably improve when choosing higher frequency resolution. A lower frequency resolution may be desired, since it results in less ICTD, ICLD, and ICC values that need to be transmitted to the decoder and thus in a lower bitrate.

Regarding time resolution, ICTD, ICLD, and ICC are typically considered at regular time intervals. High performance is obtained when ICTD, ICLD, and ICC are considered about every 4 to 16 ms. Note that, unless the cues are considered at very short time intervals, the precedence effect is not directly considered. Assuming a classical lead-lag pair of sound stimuli, if the lead and lag fall into a time interval where only one set of cues is synthesized, then localization dominance of the lead is not considered. Despite this, BCC achieves audio quality reflected in an average MUSHRA score of about 87 (i.e., "excellent" audio quality) on average and up to nearly 100 for certain audio signals.

The often-achieved perceptually small difference between reference signal and synthesized signal implies that cues related to a wide range of auditory spatial image attributes are implicitly considered by synthesizing ICTD, ICLD, and ICC at regular time intervals. In the following, some arguments are given on how ICTD, ICLD, and ICC may relate to a range of auditory spatial image attributes.

Estimation of spatial cues

In the following, it is described how ICTD, ICLD, and ICC are estimated. The bitrate for transmission of these (quantized and coded) spatial cues can be just a few kb/s and thus, with BCC, it is possible to transmit stereo and multi-channel audio signals at bitrates close to what is required for a single audio channel.

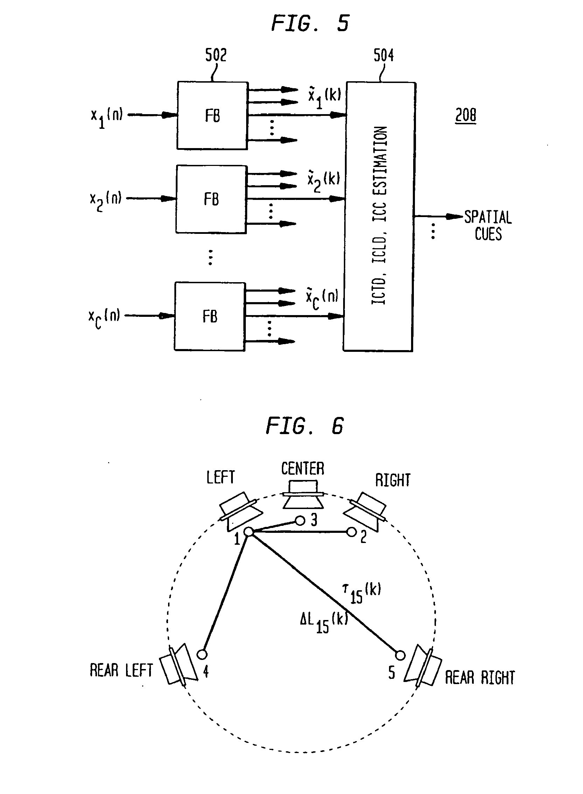

Fig. 5 shows a block diagram of BCC estimator **208** of Fig. 2, according to one embodiment of the present invention. BCC estimator **208** comprises filterbanks (FB) **502,** which may be the same as filterbanks 302 of Fig. 3, and estimation block **504,** which generates ICTD, ICLD, and ICC spatial cues for each different frequency subband generated by filterbanks **502.**

Estimation of ICTD, ICLD, and ICC for stereo signals

The following measures are used for ICTD, ICLD, and ICC for corresponding subband signals $\tilde{x}_1(k)$ and $\tilde{x}_2(k)$ of two (e.g., stereo) audio channels:

　o ICTD [samples]:

$$\tau_{12}(k) = \arg\max_d \left\{ \Phi_{12}(d,k) \right\},$$ (7)

with a short-time estimate of the normalized cross-correlation function given by Equation (8) as follows:

$$\Phi_{12}(d,k) = \frac{p_{\tilde{x}_1\tilde{x}_2}(d,k)}{\sqrt{p_{\tilde{x}_1}(k-d_1)p_{\tilde{x}_2}(k-d_2)}},$$ (8)

where

$$\begin{aligned} d_1 &= \max\{-d,0\} \\ d_2 &= \max\{d,0\} \end{aligned}$$ (9)

and $p_{\tilde{x}_1\tilde{x}_2}(d)$ $k)$ is a short-time estimate of the mean of $\tilde{x}_1(k - d_1)\tilde{x}_2(k - d_2)$.

o ICLD [dB]:

$$\Delta L_{12}(k) = 10\log_{10}\left(\frac{p_{\tilde{x}_2}(k)}{p_{\tilde{x}_1}(k)}\right).$$ (10)

o ICC:

$$c_{12}(k) = \max_d \left| \Phi_{12}(d,k) \right|.$$ (11)

Note that the absolute value of the normalized cross-correlation is considered and $c_{12}(k)$ has a range of [0,1].

Estimation of ICTD. ICLD, and ICC for multi-channel audio signals

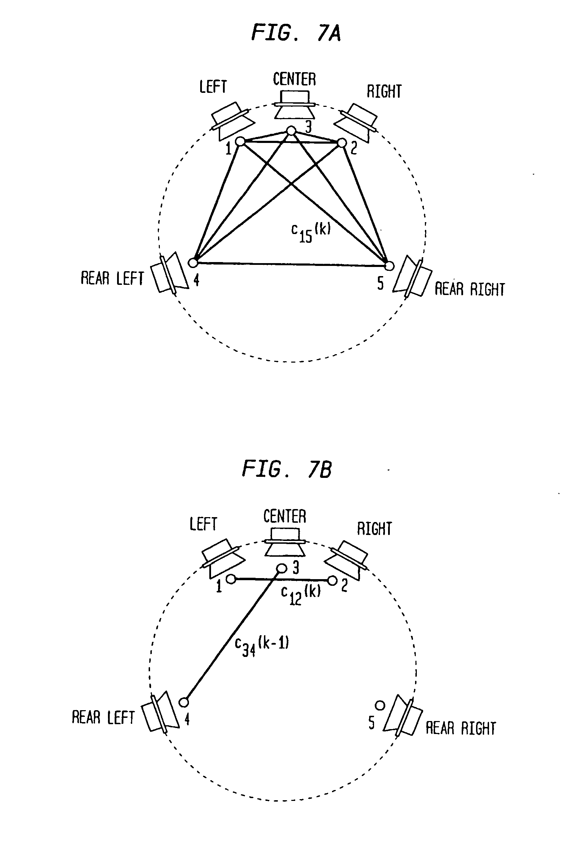

When there are more than two input channels, it is typically sufficient to define ICTD and ICLD between a reference channel (e.g., channel number 1) and the other channels, as illustrated in Fig. 6 for the case of C=5 channels where $\tau_{1c}(k)$ and $\Delta L_{12}(k)$ denote the ICTD and ICLD, respectively, between the reference channel 1 and channel c.
As opposed to ICTD and ICLD, ICC typically has more degrees of freedom. The ICC as defined can have different values between all possible input channel pairs. For $C$ channels, there are $C(C-1)/2$ possible channel pairs; e.g., for 5 channels there are 10 channel pairs as illustrated in Fig. 7(a). However, such a scheme requires that, for each subband at each time index, $C(C-1)/2$ ICC values are estimated and transmitted, resulting in high computational complexity and high bitrate.
Alternatively, for each subband, ICTD and ICLD determine the direction at which the auditory event of the corresponding signal component in the subband is rendered. One single ICC parameter per subband may then be used to describe the overall coherence between all audio channels. Good results can be obtained by estimating and transmitting ICC cues only between the two channels with most energy in each subband at each time index. This is illustrated in Fig. 7(b), where for time instants $k$-1 and $k$ the channel pairs (3, 4) and (1, 2) are strongest, respectively. A heuristic rule may be used for determining ICC between the other channel pairs.

<u>Synthesis of spatial cues</u>

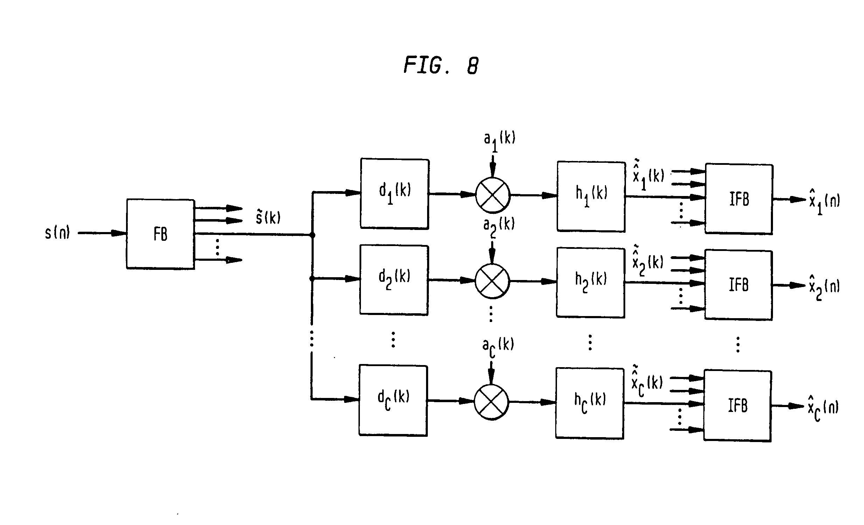

Fig. 8 shows a block diagram of an implementation of BCC synthesizer 400 of Fig. 4 that can be used in a BCC decoder to generate a stereo or multi-channel audio signal given a single transmitted sum signal $s(n)$ plus the spatial cues. The sum signal $s(n)$ is decomposed into subbands, where $\tilde{s}(k)$ denotes one such subband. For generating the corresponding subbands of each of the output channels, delays $d_c$, scale factors $a_c$, and filters $h_c$ are applied to the corresponding subband of the sum signal. (For simplicity of notation, the time index $k$ is ignored in the delays, scale factors, and filters.) ICTD are synthesized by imposing delays, ICLD by scaling, and ICC by applying de-correlation filters. The processing shown in Fig. 8 is applied independently to each subband.

<u>ICTD synthesis</u>

The delays $d_c$ are determined from the ICTDs $\tau_{1c}(k)$ , according to Equation (12) as follows:

$$d_c = \begin{cases} -\dfrac{1}{2}\left(\max_{2\leq l\leq C}\tau_{1l}(k) + \min_{2\leq l\leq C}\tau_{1l}(k)\right), & c = 1 \\ \tau_{1l}(k) + d_1 & 2 \leq c \leq C. \end{cases} \qquad (12)$$

The delay for the reference channel, $d_1$, is computed such that the maximum magnitude of the delays $d_c$ is minimized. The less the subband signals are modified, the less there is a danger for artifacts to occur. If the subband sampling rate does not provide high enough time-resolution for ICTD synthesis, delays can be imposed more precisely by using suitable all-pass filters.

<u>ICLD synthesis</u>

In order that the output subband signals have desired ICLDs $\Delta L_{12}(k)$ between channel c and the reference channel 1, the gain factors $a_c$ should satisfy Equation (13) as follows:

$$\frac{a_c}{a_1} = 10^{\frac{\Delta L_{1c}(k)}{20}}. \qquad (13)$$

Additionally, the output subbands are preferably normalized such that the sum of the power of all output channels is equal to the power of the input sum signal. Since the total original signal power in each subband is preserved in the sum signal, this normalization results in the absolute subband power for each output channel approximating the corresponding power of the original encoder input audio signal. Given these constraints, the scale factors $a_c$ are given by Equation (14) as follows:

$$a_c = \begin{cases} 1\Big/\sqrt{1 + \sum_{i=2}^{C} 10^{\Delta L_{1i}/10}}, & c = 1 \\ 10^{\Delta L_{1c}/20} a_1, & \text{otherwise.} \end{cases} \qquad (14)$$

<u>ICC synthesis</u>

In certain embodiments, the aim of ICC synthesis is to reduce correlation between the subbands after delays and scaling have been applied, without affecting ICTD and ICLD. This can be achieved by designing the filters $h_c$ in Fig. 8 such that ICTD and ICLD are effectively varied as a function of frequency such that the average variation is zero in each subband (auditory critical band).

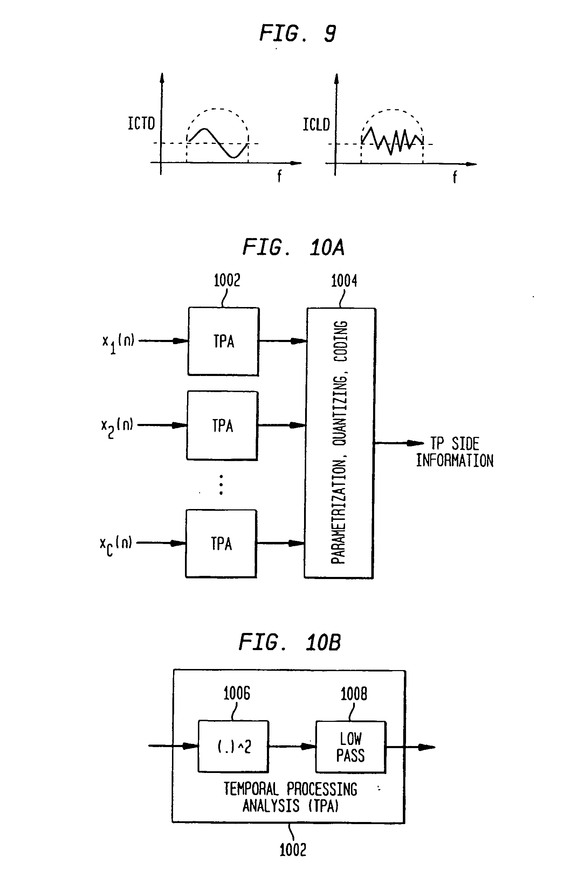

Fig. 9 illustrates how ICTD and ICLD are varied within a subband as a function of frequency. The amplitude of ICTD and ICLD variation determines the degree of de-correlation and is controlled as a function of ICC. Note that ICTD are varied smoothly (as in Fig. 9(a)), while ICLD are varied randomly (as in Fig. 9(b)). One could vary ICLD as smoothly as ICTD, but this would result in more coloration of the resulting audio signals.

Another method for synthesizing ICC, particularly suitable for multi-channel ICC synthesis, is described in more detail in C. Faller, "Parametric multi-channel audio coding: Synthesis of coherence cues," IEEE Trans. on Speech and Audio Proc., 2003.

As a function of time and frequency, specific amounts of artificial late reverberation are added to each of the output channels for achieving a desired ICC. Additionally, spectral modification can be applied such that the spectral envelope of the resulting signal approaches the spectral envelope of the original audio signal.

Other related and unrelated ICC synthesis techniques for stereo signals (or audio channel pairs) have been presented in E. Schuijers, W. Oomen, B. den Brinker, and J. Breebaart, "Advances in parametric coding for high-quality audio," in Preprint 114th Conv. Aud. Eng. Soc., Mar. 2003, and J. Engdegard, H. Purnhagen, J. Roden, and L. Liljeryd, "Synthetic ambience in parametric stereo coding," in Preprint 117th Conv. Aud. Eng. Soc., May 2004.

C-to-E BCC

As described previously, BCC can be implemented with more than one transmission channel. A variation of BCC has been described which represents *C* audio channels not as one single (transmitted) channel, but as *E* channels, denoted *C*-to-E BCC. There are (at least) two motivations for *C*-to-E BCC:

o BCC with one transmission channel provides a backwards compatible path for upgrading existing mono systems for stereo or multi-channel audio playback. The upgraded systems transmit the BCC downmixed sum signal through the existing mono infrastructure, while additionally transmitting the BCC side information. *C*-to-*E* BCC is applicable to *E*-channel backwards compatible coding of *C*-channel audio.
o *C*-to-*E* BCC introduces scalability in terms of different degrees of reduction of the number of transmitted channels. It is expected that the more audio channels that are transmitted, the better the audio quality will be.

Signal processing details for *C*-to-*E* BCC, such as how to define the ICTD, ICLD, and ICC cues, are described in U.S. 2005/0157883.

Individual Channel Shaping

In certain embodiments, both BCC with one transmission channel and *C*-to-*E* BCC involve algorithms for ICTD, ICLD, and/or ICC synthesis. Usually, it is enough to synthesize the ICTD, ICLD, and/or ICC cues about every 4 to 30 ms. However, the perceptual phenomenon of precedence effect implies that there are specific time instants when the human auditory system evaluates cues at higher time resolution (e.g., every 1 to 10 ms).

A single static filterbank typically cannot provide high enough frequency resolution, suitable for most time instants, while providing high enough time resolution at time instants when the precedence effect becomes effective.

Certain embodiments of the present invention are directed to a system that uses relatively low time resolution ICTD, ICLD, and/or ICC synthesis, while adding additional processing to address the time instants when higher time resolution is required. Additionally, in certain embodiments, the system eliminate the need for signal adaptive window switching technology which is usually hard to integrate in a system's structure. In certain embodiments, the temporal envelopes of one or more of the original encoder input audio channels are estimated. This can be done, e.g., directly by analysis of the signal's time structure or by examining the autocorrelation of the signal spectrum over frequency. Both approaches will be elaborated on further in the subsequent implementation examples. The information contained in these envelopes is transmitted to the decoder (as envelope cue codes) if perceptually required and advantageous.

In certain embodiments, the decoder applies certain processing to impose these desired temporal envelopes on its output audio channels:

o This can be achieved by TP processing, e.g., manipulation of the signal's envelope by multiplication of the signal's time-domain samples with a time-varying amplitude modification function. A similar processing can be applied to spectral/subband samples if the time resolution of the subbands is sufficiently high enough (at the cost of a coarse frequency resolution).
o Alternatively, a convolution / filtering of the signal's spectral representation over frequency can be used in a manner analogous to that used in the prior art for the purpose of shaping the quantization noise of a low-bitrate audio coder or for enhancing intensity stereo coded signals. This is preferred if the filterbank has a high frequency resolution and therefor a rather low time resolution. For the convolution/filtering approach:
o The envelope shaping method is extended from intensity stereo to *C*-to-*E* multi-channel coding.
o The technique comprises a setup where the envelope shaping is controlled by parametric information (e.g., binary flags) generated by the encoder but is actually carried out using decoder-derived filter coefficient sets.
o In another setup, sets of filter coefficients are transmitted from the encoder, e.g., only when perceptually necessary and/or beneficial.

The same is also true for the time domain/subband domain approach. Therefore, criteria (e.g., transient detection and a tonality estimate) can be introduced to additionally control transmission of envelope information.

There may be situations when it is favorable to disable the TP processing in order to avoid potential artifacts. In order to be on the safe side, it is a good strategy to leave the temporal processing disabled by default (i.e., BCC would operate according to a conventional BCC scheme). The additional processing is enabled only when it is expected that higher temporal resolution of the channels yields improvement, e.g., when it is expected that the precedence effect becomes active.

As stated earlier, this enabling/disabling control can be achieved by transient detection. That is, if a transient is detected, then TP processing is enabled. The precedence effect is most effective for transients. Transient detection can be used with look-ahead to effectively shape not only single transients but also the signal components shortly before and after the transient. Possible ways of detecting transients include:

o Observing the temporal envelope of BCC encoder input signals or transmitted BCC sum signal(s). If there is a sudden increase in power, then a transient occurred.
o Examining the linear predictive coding (LPC) gain as estimated in the encoder or decoder. If the LPC prediction gain exceeds a certain threshold, then it can be assumed that the signal is transient or highly fluctuating. The LPC analysis is computed on the spectrum's autocorrelation.

Additionally, to prevent possible artifacts in tonal signals, TP processing is preferably not applied when the tonality of the transmitted sum signal(s) is high.

According to certain embodiments of the present invention, the temporal envelopes of the individual original audio channels are estimated at a BCC encoder in order to enable a BCC decoder generate output channels with temporal envelopes similar (or perceptually similar) to those of the original audio channels. Certain embodiments of the present invention address the phenomenon of precedence effect. Certain embodiments of the present invention involve the transmission of envelope cue codes in addition to other BCC codes, such as ICLD, ICTD, and/or ICC, as part of the BCC side information.

In certain embodiments of the present invention, the time resolution for the temporal envelope cues is finer than the time resolution of other BCC codes (e.g., ICLD, ICTD, ICC). This enables envelope shaping to be performed within the time period provided by a synthesis window that corresponds to the length of a block of an input channel for which the other BCC codes are derived.

Implementation Examples

Fig. 10 shows a block diagram of time-domain processing that is added to a BCC encoder, such as encoder **202** of Fig. 2, according to one embodiment of the present invention. As shown in Fig. 10(a), each temporal process analyzer (TPA) **1002** estimates the temporal envelope of a different original input channel $x_c(n)$, although in general any one or more of the input channels can be analyzed.

Fig. 10(b) shows a block diagram of one possible time domain-based implementation of TPA 1002 in which the input signal samples are squared **(1006)** and then low-pass filtered **(1008)** to characterize the temporal envelope of the input signal. In alternative embodiments, the temporal envelope can be estimated using an autocorrelation / LPC method or with other methods, e.g., using a Hilbert transform.

Block **1004** of Fig. 10(a) parameterizes, quantizes, and codes the estimated temporal envelopes prior to transmission as temporal processing (TP) information (i.e., envelope cue codes) that is included in the side information of Fig. 2.

In one embodiment, a detector (not shown) within block **1004** determines whether TP processing at the decoder will improve audio quality, such that block **1004** transmits TP side information only during those time instants when audio quality will be improved by TP processing.

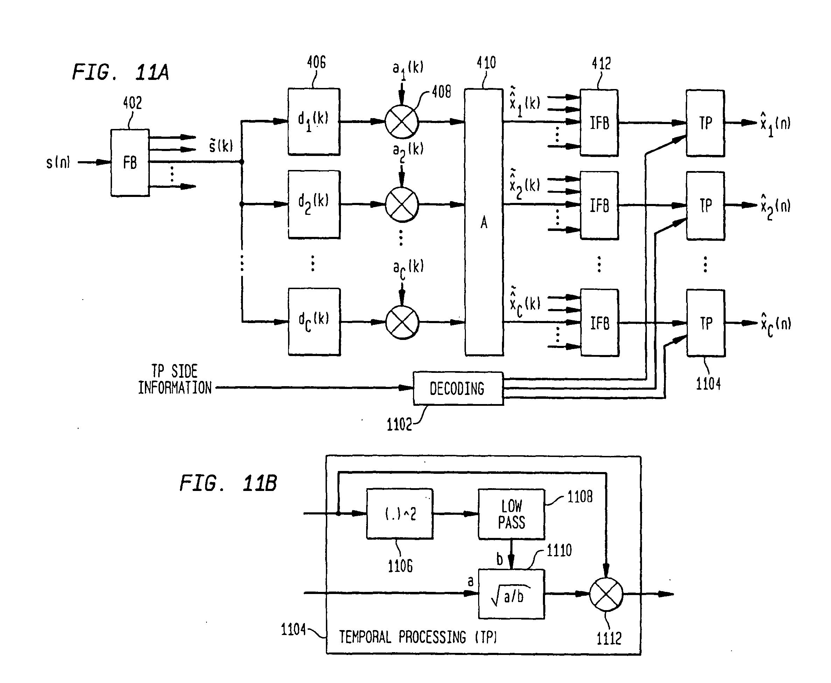

Fig. 11 illustrates an exemplary time-domain application of TP processing in the context of BCC synthesizer **400** of Fig. 4. In this embodiment, there is a single transmitted sum signal $s(n)$, C base signals are generated by replicating that sum signal, and envelope shaping is individually applied to different synthesized channels. In alternative embodiments, the order of delays, scaling, and other processing may be different. Moreover, in alternative embodiments, envelope shaping is not restricted to processing each channel independently. This is especially true for convolution/filtering-based implementations that exploit coherence over frequency bands to derive information on the signal's temporal fine structure.

In Fig. 11 (a), decoding block **1102** recovers temporal envelope signals a for each output channel from the transmitted TP side information received from the BCC encoder; and each TP block **1104** applies the corresponding envelope information to shape the envelope of the output channel.

Fig. 11(b) shows a block diagram of one possible time domain-based implementation of TP **1104** ' in which the synthesized signal samples are squared **(1106)** and then low-pass filtered **(1108)** to characterize the temporal envelope b of the synthesized channel. A scale factor (e.g., sqrt *(a/b))* is generated **(1110)** and then applied **(1112)** to the synthesized channel to generate an output signal having a temporal envelope substantially equal to that of the corresponding original input channel.

In alternative implementations of TPA **1002** of Fig. 10 and TP **1104** of Fig. 11, the temporal envelopes are characterized using magnitude operations rather than by squaring the signal samples. In such implementations, the ratio *a/b* may be used as the scale factor without having to apply the square root operation.

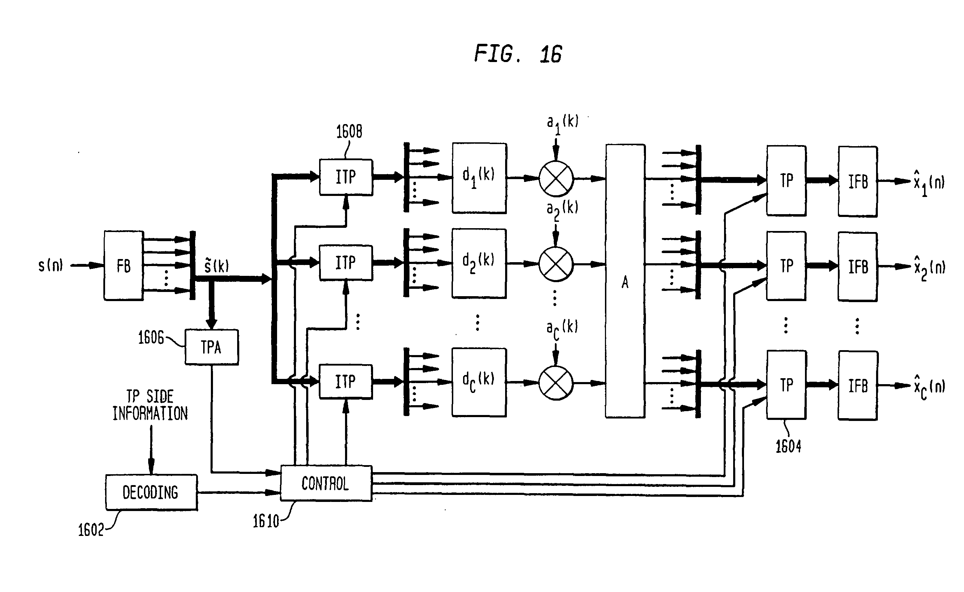

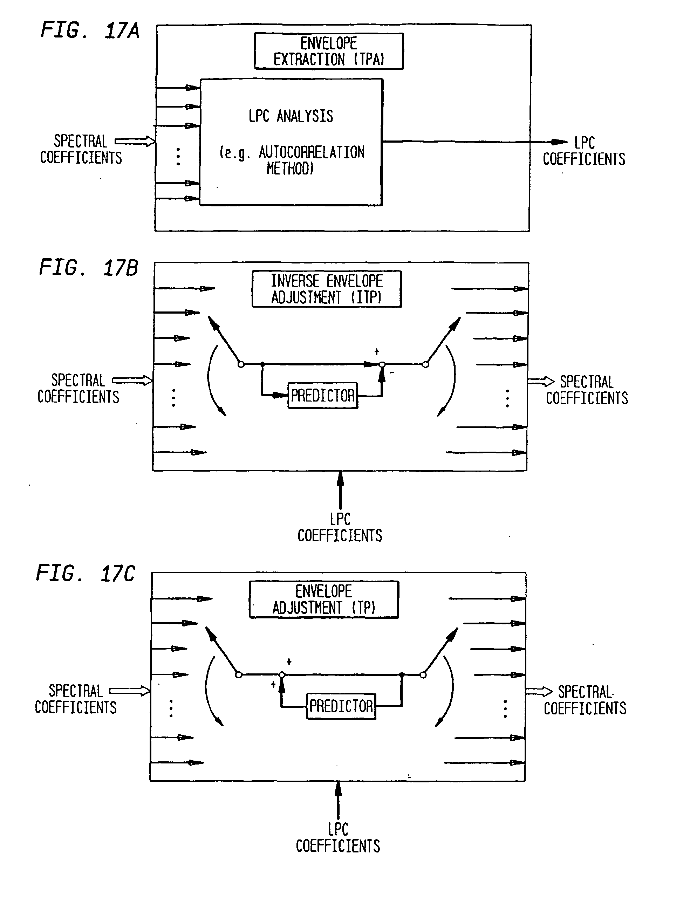

Although the scaling operation of Fig. 11 (a) corresponds to a time domain-based implementation of TP processing, TP processing (as well as TPA and inverse TP (ITP) processing) can also be implemented using frequency-domain signals, as in the embodiment of Figs. 16-17 (described below). As such, for purposes of this specification, the term "scaling function" should be interpreted to cover either time-domain or frequency-domain operations, such as the filtering operations of Figs. 17(b) and (c).

In general, each TP **1104** is preferably designed such that it does not modify signal power (i.e., energy). Depending on the particular implementation, this signal power may be a short-time average signal power in each channel, e.g., based on the total signal power per channel in the time period defined by the synthesis window or some other suitable measure of power. As such, scaling for ICLD synthesis (e.g., using multipliers **408**) can be applied before or after envelope shaping.

Since full-band scaling of the BCC output signals may result in artifacts, envelope shaping might be applied only at specified frequencies, for example, frequencies larger than a certain cut-off frequency $f_{TP}$ (e.g., 500 Hz). Note that the frequency range for analysis (TPA) may differ from the frequency range for synthesis (TP).

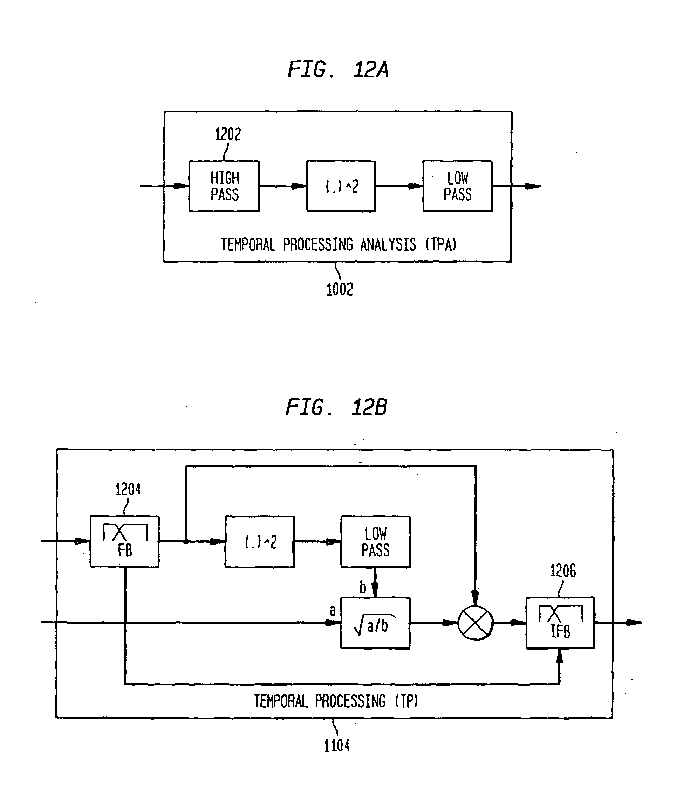

Figs. 12(a) and (b) show possible implementations of TPA **1002** of Fig. 10 and TP **1104** of Fig. 11 where envelope shaping is applied only at frequencies higher than the cut-off frequency $f_{TP}$, In particular, Fig. 12(a) shows the addition of high-pass filter **1202,** which filters out frequencies lower than $f_{TP}$ prior to temporal envelope characterization. Fig. 12(b) shows the addition of two-band filterbank **1204** having with a cut-off frequency of $f_{TP}$ between the two subbands, where only the high-frequency part is temporally shaped. Two-band inverse filterbank **1206** then recombines the low-frequency part with the temporally shaped, high-frequency part to generate the output channel.

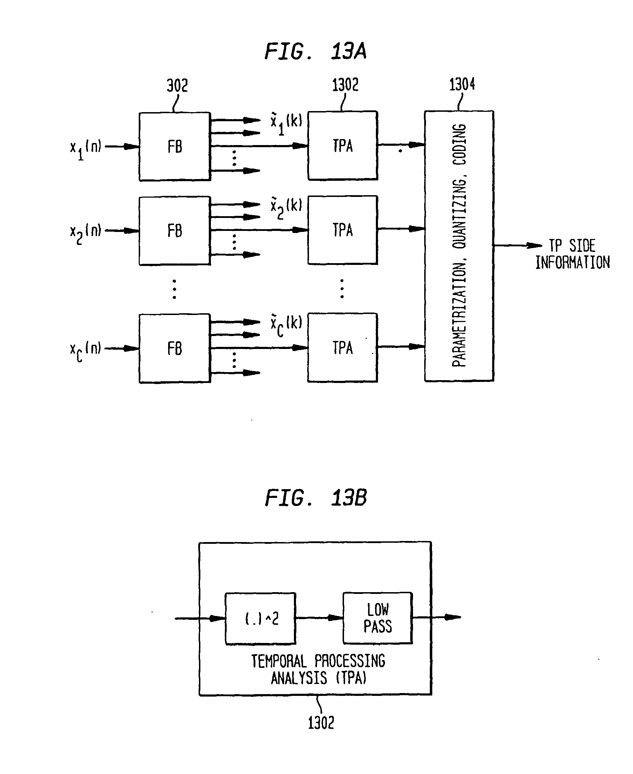

Fig. 13 shows a block diagram of frequency-domain processing that is added to a BCC encoder, such as encoder **202** of Fig. 2, according to an alternative embodiment of the present invention. As shown in Fig. 13(a), the processing of each TPA **1302** is applied individually in a different subband, where each filterbank (FB) is the same as a corresponding FB **302** of Fig. 3 and block **1304** is a subband implementation analogous to block **1004** of Fig. 10. In alternative implementations, the subbands for TPA processing may differ from the BCC subbands. As shown in Fig. 13 (b), TPA **1302** can be implemented analogous to TPA **1002** of Fig. 10.

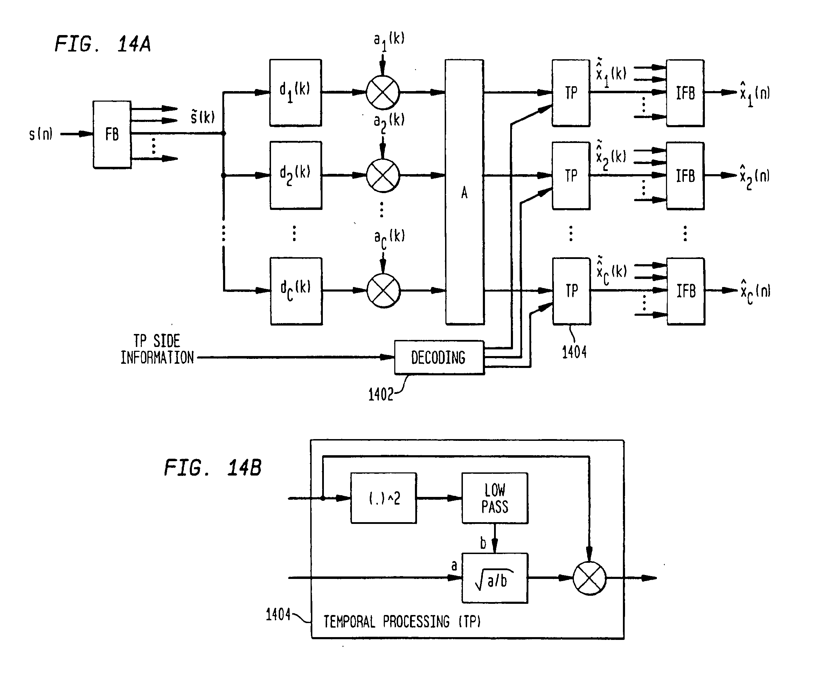

Fig. 14 illustrates an exemplary frequency-domain application of TP processing in the context of BCC synthesizer **400** of Fig. 4. Decoding block **1402** is analogous to decoding block **1102** of Fig. 11, and each TP **1404** is a subband implementation analogous to each TP **1104** of Fig. 11, as shown in Fig. 14(b).

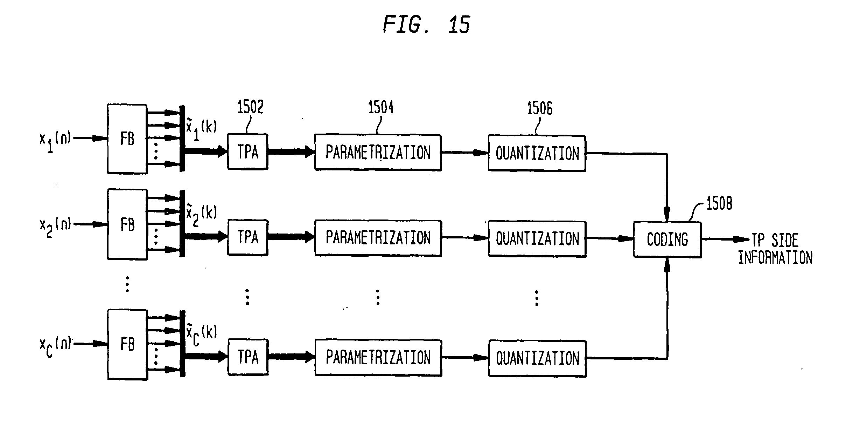

Fig. 15 shows a block diagram of frequency-domain processing that is added to a BCC encoder, such as encoder **202** of Fig. 2, according to another alternative embodiment of the present invention. This scheme has the following setup: The envelope information for every input channel is derived by calculation of LPC across frequency **(1502),** parameterized **(1504),** quantized **(1506),** and coded into the bitstream **(1508)** by the encoder. Fig. 17(a) illustrates an implementation example of the TPA **1502** of Fig. 15. The side information to be transmitted to the multichannel synthesizer (decoder) could be the LPC filter coefficients computed by an autocorrelation method, the resulting reflection coefficients, or line spectral pairs, etc., or, for the sake of keeping the side information data rate small, parameters derived from, e.g., the LPC prediction gain like "transients present/not present" binary flags.

Fig. 16 illustrates another exemplary frequency-domain application of TP processing in the context of BCC synthesizer **400** of Fig. 4. The encoding processing of Fig. 15 and the decoding processing of Fig. 16 may be implemented to form a matched pair of an encoder/decoder configuration. Decoding block **1602** is analogous to decoding block **1402** of Fig. 14, and each TP **1604** is analogous to each TP **1404** of Fig. 14. In this multichannel synthesizer, transmitted TP side information is decoded and used for controlling the envelope shaping of individual channels. In addition, however, the synthesizer includes an envelope characterizer stage (TPA) **1606** for analysis of the transmitted sum signals, an inverse TP (ITP) **1608** for "flattening" the temporal envelope of each base signal, where envelope adjusters (TP) **1604** impose a modified envelope on each output channel. Depending on the particular implementation, ITP can be applied either before or after upmixing. In detail, this is done using the convolution/filtering approach where envelope shaping is achieved by applying LPC-based filters on the spectrum across frequency as illustrated in Figs. 17(a), (b), and (c) for TPA, ITP, and TP processing, respectively. In Fig. 16, control block **1610** determines whether or not envelope shaping is to be implemented and, if so, whether it is to be based on (1) the transmitted TP side information or (2) the locally characterized envelope data from TPA **1606.**

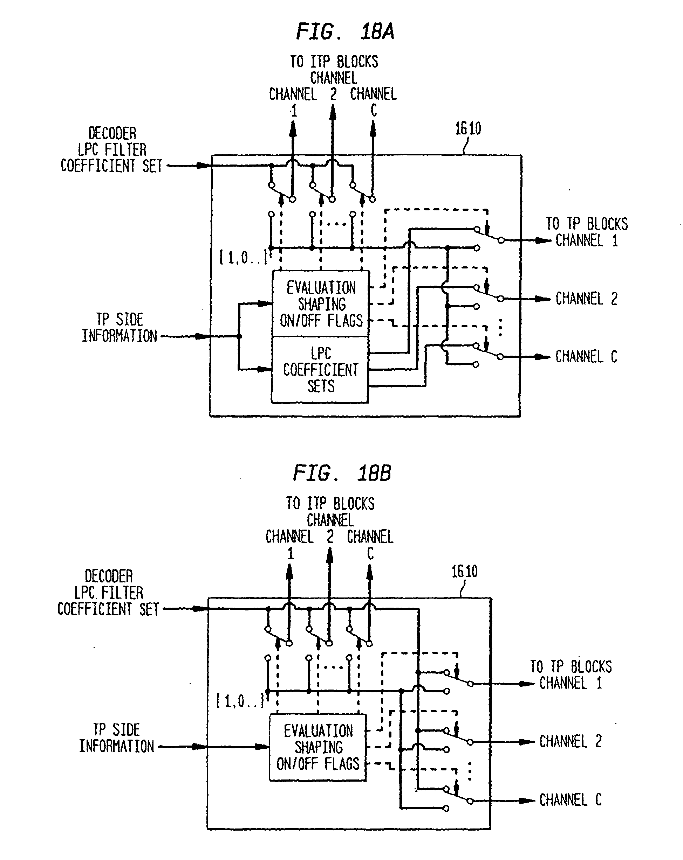

Figs. 18(a) and (b) illustrate two exemplary modes of operating control block **1610** of Fig. 16. In the implementation of Fig. 18(a), a set of filter coefficients is transmitted to the decoder, and envelope shaping by convolution/filtering is done based on the transmitted coefficients. If transient shaping is detected to be not beneficial by the encoder, then no filter data is sent and the filters are disabled (shown in Fig. 18(a) by switching to a unity filter coefficient set "[1,0...]").

In the implementation of Fig. 18(b), only a "transient/non transient flag" is transmitted for each channel and this flag is used to activate or deactivate shaping based on filter coefficient sets calculated from the transmitted downmix signals in the decoder.

Further Alternative Embodiments

Although the present invention has been described in the context of BCC coding schemes in which there is a single sum signal, the present invention can also be implemented in the context of BCC coding schemes having two or more sum signals. In this case, the temporal envelope for each different "base" sum signal can be estimated before applying BCC synthesis, and different BCC output channels may be generated based on different temporal envelopes, depending on which sum signals were used to synthesize the different output channels. An output channel that is synthesized from two or more different sum channels could be generated based on an effective temporal envelope that takes into account (e.g., via weighted averaging) the relative effects of the constituent sum channels.

Although the present invention has been described in the context of BCC coding schemes involving ICTD, ICLD, and ICC codes, the present invention can also be implemented in the context of other BCC coding schemes involving only one or two of these three types of codes (e.g., ICLD and ICC, but not ICTD) and/or one or more additional types of codes. Moreover, the sequence of BCC synthesis processing and envelope shaping may vary in different implementations. For example, when envelope shaping is applied to frequency-domain signals, as in Figs. 14 and 16, envelope shaping could alternatively be implemented after ICTD synthesis (in those embodiments that employ ICTD synthesis), but prior to ICLD synthesis. In other embodiments, envelope shaping could be applied to upmixed signals before any other BCC synthesis is applied.

Although the present invention has been described in the context of BCC encoders that generate envelope cue codes from the original input channels, in alternative embodiments, the envelope cue codes could be generated from downmixed channels corresponding to the original input channels. This would enable the implementation of a processor (e.g., a separate envelope cue coder) that could (I) accept the output of a BCC encoder that generates the downmixed channels and certain BCC codes (e.g., ICLD, ICTD, and/or ICC) and (2) characterize the temporal envelope (s) of one or more of the downmixed channels to add envelope cue codes to the BCC side information.

Although the present invention has been described in the context of BCC coding schemes in which the envelope cue codes are transmitted with one or more audio channels (i.e., the E transmitted channels) along with other BCC codes, in alternative embodiments, the envelope cue codes could be transmitted, either alone or with other BCC codes, to a place (e.g., a decoder or a storage device) that already has the transmitted channels and possibly other BCC codes.

Although the present invention has been described in the context of BCC coding schemes, the present invention can also be implemented in the context of other audio processing systems in which audio signals are de-correlated or other audio processing that needs to de-correlate signals.

Although the present invention has been described in the context of implementations in which the encoder receives input audio signal in the time domain and generates transmitted audio signals in the time domain and the decoder receives the transmitted audio signals in the time domain and generates playback audio signals in the time domain, the present invention is not so limited. For example, in other implementations, any one or more of the input, transmitted, and playback audio signals could be represented in a frequency domain.

BCC encoders and/or decoders may be used in conjunction with or incorporated into a variety of different applications or systems, including systems for television or electronic music distribution, movie theaters, broadcasting, streaming, and/or reception. These include systems for encoding/decoding transmissions via, for example, terrestrial, satellite, cable, internet, intranets, or physical media (e.g., compact discs, digital versatile discs, semiconductor chips, hard drives, memory cards, and the like). BCC encoders and/or decoders may also be employed in games and game systems, including, for example, interactive software products intended to interact with a user for entertainment (action, role play, strategy, adventure, simulations, racing, sports, arcade, card, and board games) and/or education that may be published for multiple machines, platforms, or media. Further, BCC encoders and/or decoders may be incorporated in audio recorders/players or CD-ROM/DVD systems. BCC encoders and/or decoders may also be incorporated into PC software applications that incorporate digital decoding (e.g., player, decoder) and software applications incorporating digital encoding capabilities (e.g., encoder, ripper, recoder, and jukebox).

The present invention may be implemented as circuit-based processes, including possible implementation as a single integrated circuit (such as an ASIC or an FPGA), a multi-chip module, a single card, or a multi-card circuit pack. As would be apparent to one skilled in the art, various functions of circuit elements may also be implemented as processing steps in a software program. Such software may be employed in, for example, a digital signal processor, micro-controller, or general-purpose computer.

The present invention can be embodied in the form of methods and apparatuses for practicing those methods. The present invention can also be embodied in the form of program code embodied in tangible media, such as floppy diskettes, CD-ROMs, hard drives, or any other machine-readable storage medium, wherein, when the program code is loaded into and executed by a machine, such as a computer, the machine becomes an apparatus for practicing the invention. The present invention can also be embodied in the form of program code, for example, whether stored in a storage medium, loaded into and/or executed by a machine, or transmitted over some transmission medium or carrier, such as over electrical wiring or cabling, through fiber optics, or via electromagnetic radiation, wherein, when the program code is loaded into and executed by a machine, such as a computer, the machine becomes an apparatus for practicing the invention. When implemented on a general-purpose processor, the program code segments combine with the processor to provide a unique device that operates analogously to specific logic circuits.

It will be further understood that various changes in the details, materials, and arrangements of the parts which have been described and illustrated in order to explain the nature of this invention may be made by those skilled in the art without departing from the scope of the invention as expressed in the following claims.

Although the steps in the following method claims, if any, are recited in a particular sequence with corresponding labeling, unless the claim recitations otherwise imply a particular sequence for implementing some or all of those steps, those steps are not necessarily intended to be limited to being implemented in that particular sequence.

**Claims**

1. A method for encoding audio channels, the method comprising:

    generating two or more cue codes for one or more audio channels, wherein at least one cue code is an envelope cue code generated by characterizing a temporal envelope in one of the one or more audio channels, wherein the two or more cue codes further comprise one or more of inter-channel correlation (ICC) codes, inter-channel level difference (ICLD) codes, and inter-channel time difference (ICTD) codes, wherein a first time resolution associated with the envelope cue code is finer than a second time resolution associated with the other cue code(s), and wherein the temporal envelope is **characterized** for the corresponding audio channel in a time domain or individually for different signal sub bands of the corresponding audio channel in a sub band domain; and
    transmitting the two or more cue codes.

2. The method of claim 1, further comprising transmitting E transmitted audio channel(s) corresponding to the one or more audio channels, where $E \geq 1$.

3. The method of claim 2, wherein:
    the one or more audio channels comprise C input audio channels, where $C > E$; and
    the C input channels are downmixed to generate the E transmitted channel(s).

4. The method of claim 1, wherein the two or more cue codes are transmitted to enable a decoder to perform envelope shaping during decoding of E transmitted channel(s) based on the two or more cue codes, wherein the E transmitted audio channel(s) correspond to the one or more audio channels, where $E \geq 1$.

5. The method of claim 4, wherein the envelope shaping adjusts a temporal envelope of a synthesized signal generated by the decoder to match the **characterized** temporal envelope.

6. The method of claim 1, wherein the temporal envelope is **characterized** only for specified frequencies of the corresponding audio channel.

7. The method of claim 1, wherein the temporal envelope is **characterized** only for frequencies of the corresponding audio channel above a specified cutoff frequency.

8. The method of claim 1, wherein the sub band domain corresponds to a quadrature mirror filter (QMF).

9. The method of claim 1, further comprising determining whether to enable or disable the characterizing.

**10.** The method of claim 9, further comprising generating and transmitting an enable/disable flag based on the determining to instruct a decoder whether or not to implement envelope shaping during decoding of E transmitted channel(s) corresponding to the one or more audio channels, where $E \geq 1$.

**11.** The method of claim 9, wherein the determining is based on analyzing an audio channel to detect transients in the audio channel such that the characterizing is enabled if occurrence of a transient is detected.

**12.** The method of claim 1, in which the step of generating the envelope cue code includes squaring (1006) or forming a magnitude and low-pass filtering (1008) of signal samples of the audio channel or of sub band signals of the audio channel in order to characterize the temporal envelope.

**13.** The method of claim 1 or 12, in which the step of generating furthermore comprises a step of parametrizing, quantizing and coding an estimated temporal envelope

**14.** Apparatus for encoding audio channels, the apparatus comprising:

means for generating two or more cue codes for one or more audio channels, wherein at least one cue code is an envelope cue code generated by characterizing a temporal envelope in one of the one or more audio channels, wherein the two or more cue codes further comprise one or more of inter-channel correlation (ICC) codes, inter-channel level difference (ICLD) codes, and inter-channel time difference (ICTD) codes, wherein a first time resolution associated with the envelope cue code is finer than a second time resolution associated with the other cue code(s), and wherein the temporal envelope is **characterized** for the corresponding audio channel in a time domain or individually for different signal sub bands of the corresponding audio channel in a sub band domain; and
means for transmitting information about the two or more cue codes.

**15.** The apparatus of claim 14,
wherein the apparatus is operative for encoding $C$ input audio channels to generate E transmitted audio channel(s),
wherein the means for generating comprises an envelope analyzer adapted to characterize the input temporal envelope of at least one of the $C$ input channels,
wherein the means for generating further comprises a code estimator adapted to generate the cue codes for two or more of the $C$ input channels" and
wherein the apparatus further comprises a downmixer adapted to downmix the $C$ input channels to generate the E transmitted channel(s), where $C>E \geq 1$,
wherein the means for transmitting is adapted to transmit the information about the two or more cue codes to enable a decoder to perform synthesis and envelope shaping during decoding of the E transmitted channel(s).

**16.** The apparatus of claim 15, wherein:

the apparatus is a system selected from the group consisting of a digital video recorder, a digital audio recorder, a computer, a satellite transmitter, a cable transmitter, a terrestrial broadcast transmitter, a home entertainment system, and a movie theater system; and
the system comprises the envelope analyzer, the code estimator, and the downmixer.

**17.** A computer program product, having program code, wherein, when the program code is executed by a machine, the machine implements a method of claim 1.

**18.** An encoded audio bitstream having:

two or more cue codes generated for one or more audio channels, wherein at least one cue code is an envelope cue code generated by characterizing a temporal envelope in one of the one or more audio channels, wherein the two or more cue codes further comprise one or more of inter-channel correlation (ICC) codes, inter-channel level difference (ICLD) codes, and inter-channel time difference (ICTD) codes, wherein a first time resolution associated with the envelope cue code is finer than a second time resolution associated with the other cue code(s), and wherein the temporal envelope is **characterized** for the corresponding audio channel in a time domain or individually for different signal sub bands of the corresponding audio channel in a sub band domain; and
the two or more cue codes and E transmitted audio channel(s) corresponding to the one or more audio channels, where $E \geq 1$, are encoded into the encoded audio bitstream.

**19.** The encoded audio bitstream of claim 18, further comprising $E$ transmitted audio channel(s), wherein
the E transmitted audio channel(s) correspond to the one or more audio channels.

**20.** A method for decoding $E$ transmitted audio channel(s) to generate $C$ playback audio channels, where $C > E \geq 1$, the method comprising:

receiving cue codes corresponding to the $E$ transmitted channel(s), wherein the cue codes comprise an envelope cue code corresponding to a **characterized** temporal envelope of an audio channel corresponding to the E transmitted channel(s), wherein the two or more cue codes further comprise one or more of interchannel correlation (ICC) codes, inter-channel level difference (ICLD) codes, and inter-channel time difference (ICTD) codes, wherein a first time resolution associated with the envelope cue code is finer than a second time resolution associated with the other cue code(s);
upmixing one or more of the $E$ transmitted channel(s) to generate one or more upmixed channels; and
synthesizing one or more of the $C$ playback channels by applying the cue codes to the one or more upmixed channels, wherein the envelope cue code is applied to an upmixed channel or a synthesized signal to adjust a temporal envelope of the synthesized signal based on the **characterized** temporal envelope by scaling time domain or sub band domain signal samples using a scaling factor such that the adjusted temporal envelope matches the **characterized** temporal envelope.

**21.** The method of claim 20, wherein the envelope cue code corresponds to a **characterized** temporal envelope in an original input channel used to generate the $E$ transmitted channel(s).

**22.** The method of claim 21, wherein the synthesis comprises late-reverberation ICC synthesis.

**23.** The method of claim 21, wherein the temporal envelope of the synthesized signal is adjusted prior to ICLD synthesis.

**24.** The method of claim 20, wherein:

the temporal envelope of the synthesized signal is **characterized**; and
the temporal envelope of the synthesized signal is adjusted based on both the **characterized** temporal envelope corresponding to the envelope cue code and the **characterized** temporal envelope of the synthesized signal.

**25.** The method of claim 24, wherein:

a scaling function is generated based on the **characterized** temporal envelope corresponding to the envelope cue code and the **characterized** temporal envelope of the synthesized signal; and
the scaling function is applied to the synthesized signal.

**26.** The method of claim 20, further comprising adjusting a transmitted channel based on the **characterized** temporal envelope to generate a flattened channel, wherein the upmixing and synthesis are applied to the flattened channel to generate a corresponding playback channel.

**27.** The method of claim 20, further comprising adjusting an upmixed channel based on the **characterized** temporal envelope to generate a flattened channel, wherein the synthesis is applied to the flattened channel to generate a corresponding playback channel.

**28.** The method of claim 20, wherein the temporal envelope of the synthesized signal is adjusted only for specified frequencies.

**29.** The method of claim 28, wherein the temporal envelope of the synthesized signal is adjusted only for frequencies above a specified cutoff frequency.

**30.** The method of claim 20, wherein temporal envelopes are adjusted individually for different signal sub bands in the synthesized signal.

**31.** The method of claim 20, wherein a sub band domain corresponds to a QMF.

**32.** The method of claim 20, wherein the temporal envelope of the synthesized signal is adjusted in a time domain.

**33.** The method of claim 20, further comprising determining whether to enable or disable the adjusting of the temporal envelope of the synthesized signal.

**34.** The method of claim 33, wherein the determining is based on an enable/disable flag generated by an audio encoder that generated the E transmitted channel(s).

**35.** The method of claim 33, wherein the determining is based on analyzing the E transmitted channel(s) to detect transients such that the adjusting is enabled if occurrence of a transient is detected.

**36.** The method of claim 20, further comprising:

characterizing a temporal envelope of a transmitted channel; and
determining whether to use (1) the **characterized** temporal envelope corresponding to the envelope cue code or (2) the **characterized** temporal envelope of the transmitted channel to adjust the temporal envelope of the synthesized signal.

**37.** The method of claim 20, wherein power within a specified window of the synthesized signal after adjusting the temporal envelope is equal to power within a corresponding window of the synthesized signal before the adjusting.

**38.** The method of claim 37, wherein the specified window corresponds to a synthesis window associated with one or more non-envelope cue codes.

**39.** Apparatus for decoding *E* transmitted audio channel(s) to generate *C* playback audio channels, where *C>E>*1, the apparatus comprising:

means for receiving cue codes corresponding to the *E* transmitted channel(s), wherein the cue codes comprise an envelope cue code corresponding to a **characterized** temporal envelope of an audio channel corresponding to the E transmitted channels, wherein the two or more cue codes further comprise one or more of inter-channel correlation (ICC) codes, inter-channel level difference (ICLD) codes, and interchannel time difference (ICTD) codes, wherein a first time resolution associated with the envelope cue code is finer than a second time resolution associated with the other cue code(s);
means for upmixing one or more of the E transmitted channels to generate one or more upmixed channels; and
means for synthesizing one or more of the *C* playback channels by applying the cue codes to the one or more upmixed channels, wherein the envelope cue code is applied to an upmixed channel or a synthesized signal to adjust a temporal envelope of the synthesized signal based on the **characterized** temporal envelope by scaling time domain or sub band domain signal samples using a scaling factor such that the adjusted temporal envelope matches the **characterized** temporal envelope.

**40.** The apparatus of claim 39, wherein:

the apparatus is a system selected from the group consisting of a digital video player, a digital audio player, a computer, a satellite receiver, a cable receiver, a terrestrial broadcast receiver, a home entertainment system, and a movie theater system; and
the system comprises the receiver, the upmixer, the synthesizer, and the envelope adjuster.

**41.** A computer program product having program code, wherein, when the program code is executed by a machine, the machine implements a method for decoding of claim 20.

**Patentansprüche**

**1.** Ein Verfahren zum Codieren von Audiokanälen, wobei das Verfahren folgende Schritte umfasst:

Erzeugen zweier oder mehrerer Hinweiscodes für einen oder mehr Audiokanäle, wobei zumindest ein Hinweiscode ein Hüllkurvenhinweiscode ist, der erzeugt wird, indem eine zeitliche Hüllkurve in einem des einen oder der mehreren Audiokanäle charakterisiert wird, wobei die zwei oder mehr Hinweiscodes ferner einen oder mehr von Zwischenkanal-Korrelationscodes (ICC-Codes, ICC = inter-channel correlation), Zwischenkanal-Pegeldifferenz-Codes (ICLD-Codes, ICLD = inter-channel level difference) und Zwischenkanal-Zeitdifferenz-Codes (ICTD-Codes, ICTD = inter-channel time difference) umfassen, wobei eine dem Hüllenkurvenhinweiscode zugeordnete erste Zeitauflösung feiner ist als eine dem beziehungsweise den anderen Hinweiscode(s) zugeordnete zweite Zeitauflösung, und wobei die zeitliche Hüllkurve für den entsprechenden Audiokanal in einer Zeitdomäne oder individuell für verschiedene Signalteilbänder des entsprechenden Audiokanals in einer Teilbanddomäne charakterisiert ist; und
Senden der zwei oder mehreren Hinweiscodes.

2. Das Verfahren gemäß Anspruch 1, das ferner ein Senden eines *E* gesendeten Audiokanals beziehungsweise von *E* gesendeten Audiokanälen, der beziehungsweise die dem einen oder den mehreren Audiokanälen entspricht beziehungsweise entsprechen, wobei *E≥1*, umfasst.

3. Das Verfahren gemäß Anspruch 2, bei dem:

der eine oder die mehreren Audiokanäle *C* Eingangsaudiokanäle, wobei *C>E,* umfassen; und
die C Eingangskanäle abwärtsgemischt werden, um den *E* gesendeten Kanal beziehungsweise die E gesendeten Kanäle zu erzeugen.

4. Das Verfahren gemäß Anspruch 1, bei dem die zwei oder mehr Hinweiscodes gesendet werden, um einen Decodierer zu befähigen, während eines Decodierens eines E gesendeten Kanals beziehungsweise von *E* gesendeten Kanälen auf der Basis der zwei oder mehreren Hinweiscodes eine Hüllkurvenformung durchzuführen, wobei der *E* gesendete Audiokanal beziehungsweise die E gesendeten Audiokanäle dem einen oder den mehreren Audiokanälen entspricht beziehungsweise entsprechen, wobei *E≥1*.

5. Das Verfahren gemäß Anspruch 4, bei dem die Hüllkurvenformung eine zeitliche Hüllkurve eines durch den Decodierer erzeugten synthetisierten Signals dahin gehend anpasst, dass sie mit der charakterisierten zeitlichen Hüllkurve übereinstimmt.

6. Das Verfahren gemäß Anspruch 1, bei dem die zeitliche Hüllkurve lediglich für festgelegte Frequenzen des entsprechenden Audiokanals charakterisiert ist.

7. Das Verfahren gemäß Anspruch 1, bei dem die zeitliche Hüllkurve lediglich für Frequenzen des entsprechenden Audiokanals charakterisiert ist, die oberhalb einer festgelegten Grenzfrequenz liegen.

8. Das Verfahren gemäß Anspruch 1, bei dem die Teilbanddomäne einem Quadraturspiegelfilter (QMF - quadrature mirror filter) entspricht.

9. Das Verfahren gemäß Anspruch 1, das ferner ein Bestimmen umfasst, ob die Charakterisierung freigegeben oder gesperrt wird.

10. Das Verfahren gemäß Anspruch 9, das ferner ein Erzeugen und Senden eines Freigeben/Sperren-Flags auf der Basis des Bestimmens umfasst, einen Decodierer anzuweisen, ob während des Decodierens des E gesendeten Kanals beziehungsweise der E gesendeten Kanäle, der beziehungsweise die dem einen oder den mehreren Audiokanälen entspricht beziehungsweise entsprechen, wobei *E≥1*, eine Hüllkurvenformung implementiert werden soll oder nicht.

11. Das Verfahren gemäß Anspruch 9, bei dem das Bestimmen auf einem Analysieren eines Audiokanals, um Einschwingvorgänge in dem Audiokanal zu erfassen, beruht, so dass das Charakterisieren freigegeben wird, falls ein Auftretensfall eines Einschwingvorgangs erfasst wird.

12. Das Verfahren gemäß Anspruch 1, bei dem der Schritt des Erzeugens des Hüllkurvenhinweiscodes ein Quadrieren (1006) oder Bilden eines Betrags und Tiefpassfiltern (1008) von Signalabtastwerten des Audiokanals oder von Teilbandsignalen des Audiokanals, um die zeitliche Hüllkurve zu charakterisieren, umfasst.

13. Das Verfahren gemäß Anspruch 1 oder 12, bei dem der Schritt des Erzeugens ferner einen Schritt des Parametrisierens, Quantisierens und Codierens einer geschätzten zeitlichen Hüllkurve umfasst.

**14.** Vorrichtung zum Codieren von Audiokanälen, wobei die Vorrichtung folgende Merkmale aufweist:

eine Einrichtung zum Erzeugen zweier oder mehrerer Hinweiscodes für einen oder mehr Audiokanäle, wobei zumindest ein Hinweiscode ein Hüllkurvenhinweiscode ist, der erzeugt wird, indem eine zeitliche Hüllkurve in einem des einen oder der mehreren Audiokanäle charakterisiert wird, wobei die zwei oder mehr Hinweiscodes ferner einen oder mehr von Zwischenkanal-Korrelationscodes (ICC-Codes, ICC = inter-channel correlation), Zwischenkanal-Pegeldifferenz-Codes (ICLD-Codes, ICLD = inter-channel level difference) und Zwischenkanal-Zeitdifferenz-Codes (ICTD-Codes, ICTD = inter-channel time difference) umfassen, wobei eine dem Hüllenkurvenhinweiscode zugeordnete erste Zeitauflösung feiner ist als eine dem beziehungsweise den anderen Hinweiscode(s) zugeordnete zweite Zeitauflösung, und wobei die zeitliche Hüllkurve für den entsprechenden Audiokanal in einer Zeitdomäne oder individuell für verschiedene Signalteilbänder des entsprechenden Audiokanals in einer Teilbanddomäne charakterisiert ist; und
eine Einrichtung zum Senden der zwei oder mehreren Hinweiscodes.

**15.** Die Vorrichtung gemäß Anspruch 14,
wobei die Vorrichtung dahin gehend wirksam ist, $C$ Eingangsaudiokanäle zu codieren, um einen $E$ gesendeten Audiokanal beziehungsweise $E$ gesendete Audiokanäle zu erzeugen,
wobei die Einrichtung zum Erzeugen einen Hüllkurvenanalysator umfasst, der dahin gehend angepasst ist, die eingegebene zeitliche Hüllkurve zumindest eines der $C$ Eingangskanäle zu charakterisieren,
wobei die Einrichtung zum Erzeugen ferner eine Codeschätzeinrichtung umfasst, die dahin gehend angepasst ist, die Hinweiscodes für zwei oder mehr der $C$ Eingangskanäle zu erzeugen, und
wobei die Vorrichtung ferner einen Abwärtsmischer umfasst, der dahin gehend angepasst ist, die $C$ Eingangskanäle abwärtszumischen, um den $E$ gesendeten Kanal beziehungsweise die $E$ gesendeten Kanäle zu erzeugen, wobei $C>E>1$,
wobei die Einrichtung zum Senden dahin gehend angepasst ist, die Information über die zwei oder mehreren Hinweiscodes zu senden, um einen Decodierer zu befähigen, während des Decodierens des $E$ gesendeten Kanals beziehungsweise der $E$ gesendeten Kanäle eine Synthese und Hüllkurvenformung durchzuführen.

**16.** Die Vorrichtung gemäß Anspruch 15, wobei:

die Vorrichtung ein System ist, das aus der Gruppe ausgewählt ist, die aus einem digitalen Videorecorder, einem digitalen Audiorecorder, einem Computer, einem Satellitensender, einem Kabelsender, einem terrestrischen Rundfunksender, einem Unterhaltungssystem und einem Kinosystem besteht; und
das System den Hüllkurvenanalysator, die Codeschätzeinrichtung und den Abwärtsmischer umfasst.

**17.** Ein Computerprogrammprodukt, das einen Programmcode aufweist, bei dem, wenn der Programmcode durch eine Maschine ausgeführt wird, die Maschine ein Verfahren gemäß Anspruch 1 implementiert.

**18.** Ein codierter Audiobitstrom, der folgende Merkmale aufweist:

zwei oder mehr Hinweiscodes, die für einen oder mehr Audiokanäle erzeugt sind, wobei zumindest ein Hinweiscode ein Hüllkurvenhinweiscode ist, der erzeugt wird, indem eine zeitliche Hüllkurve in einem des einen oder der mehreren Audiokanäle charakterisiert wird, wobei die zwei oder mehr Hinweiscodes ferner einen oder mehr von Zwischenkanal-Korrelationscodes (ICC-Codes, ICC = inter-channel correlation), Zwischenkanal-Pegeldifferenz-Codes (ICLD-Codes, ICLD = inter-channel level difference) und Zwischenkanal-Zeitdifferenz-Codes (ICTD-Codes, ICTD = inter-channel time difference) umfassen, wobei eine dem Hüllenkurvenhinweiscode zugeordnete erste Zeitauflösung feiner ist als eine dem beziehungsweise den anderen Hinweiscode(s) zugeordnete zweite Zeitauflösung, und wobei die zeitliche Hüllkurve für den entsprechenden Audiokanal in einer Zeitdomäne oder individuell für verschiedene Signalteilbänder des entsprechenden Audiokanals in einer Teilbanddomäne charakterisiert ist; und

wobei die zwei oder mehreren Hinweiscodes und der $E$ gesendete Audiokanal beziehungsweise die E gesendeten Audiokanäle, der beziehungsweise die dem einen oder den mehreren Audiokanälen entspricht beziehungsweise entsprechen, wobei $E>1$, in den codierten Audiobitstrom codiert sind.

**19.** Der codierte Audiobitstrom gemäß Anspruch 18, der ferner einen $E$ gesendeten Audiokanal beziehungsweise $E$ gesendete Audiokanäle umfasst, wobei
der $E$ gesendete Audiokanal beziehungsweise die $E$ gesendeten Audiokanäle dem einen oder den mehreren Audiokanälen entspricht beziehungsweise entsprechen.

**20.** Ein Verfahren zum Decodieren eines *E* gesendeten Audiokanals beziehungsweise von *E* gesendeten Audiokanälen, um *C* Wiedergabe-Audiokanäle zu erzeugen, wobei C>E>1, wobei das Verfahren folgende Schritte umfasst:

Empfangen von Hinweiscodes, die dem *E* gesendeten Kanal beziehungsweise den *E* gesendeten Kanälen entsprechen, wobei die Hinweiscodes einen Hüllkurvenhinweiscode umfassen, der einer charakterisierten zeitlichen Hüllkurve eines Audiokanals entspricht, der dem E gesendeten Kanal beziehungsweise den E gesendeten Kanälen entspricht, wobei die zwei oder mehr Hinweiscodes ferner einen oder mehr von Zwischenkanal-Korrelationscodes (ICC-Codes), Zwischenkanal-Pegeldifferenz-Codes (ICLD-Codes) und Zwischenkanal-Zeitdifferenz-Codes (ICTD-Codes) umfassen, wobei eine dem Hüllenkurvenhinweiscode zugeordnete erste Zeitauflösung feiner ist als eine dem beziehungsweise den anderen Hinweiscode(s) zugeordnete zweite Zeitauflösung; Aufwärtsmischen eines oder mehrerer des *E* gesendeten Kanals beziehungsweise der E gesendeten Kanäle, um einen oder mehr aufwärtsgemischte Kanäle zu erzeugen; und Synthetisieren eines oder mehrerer der *C* Wiedergabekanäle durch Anlegen der Hinweiscodes an den einen oder die mehreren aufwärtsgemischten Kanäle, wobei der Hüllkurvenhinweiscode an einen aufwärtsgemischten Kanal oder ein synthetisiertes Signal angelegt wird, um eine zeitliche Hüllkurve des synthetisierten Signals auf der Basis der charakterisierten zeitlichen Hüllkurve einzustellen, indem Zeitdomänen- oder Teilbanddomänen-Signalabtastwerte unter Verwendung eines Skalierungsfaktors skaliert werden, derart, dass die eingestellte zeitliche Hüllkurve mit der charakterisierten zeitlichen Hüllkurve übereinstimmt.

**21.** Das Verfahren gemäß Anspruch 20, bei dem der Hüllkurvenhinweiscode einer charakterisierten zeitlichen Hüllkurve in einem ursprünglichen Eingangskanal entspricht, der zum Erzeugen des E gesendeten Kanals beziehungsweise der E gesendeten Kanäle verwendet wird.

**22.** Das Verfahren gemäß Anspruch 21, bei dem die Synthese eine Später-Nachhall-ICC-Synthese umfasst.

**23.** Das Verfahren gemäß Anspruch 21, bei dem die zeitliche Hüllkurve des synthetisierten Signals vor einer ICLD-Synthese eingestellt wird.

**24.** Das Verfahren gemäß Anspruch 20, bei dem:

die zeitliche Hüllkurve des synthetisierten Signals charakterisiert wird; und die zeitliche Hüllkurve des synthetisierten Signals auf der Basis sowohl der charakterisierten zeitlichen Hüllkurve, die dem Hüllkurvenhinweiscode entspricht, als auch der charakterisierten zeitlichen Hüllkurve des synthetisierten Signals eingestellt wird.

**25.** Das Verfahren gemäß Anspruch 24, bei dem:

eine Skalierungsfunktion auf der Basis der charakterisierten zeitlichen Hüllkurve, die dem Hüllkurvenhinweiscode entspricht, und der charakterisierten zeitlichen Hüllkurve des synthetisierten Signals erzeugt wird; und die Skalierungsfunktion auf das synthetisierte Signal angewendet wird.

**26.** Das Verfahren gemäß Anspruch 20, das ferner ein Einstellen eines gesendeten Kanals auf der Basis der charakterisierten zeitlichen Hüllkurve umfasst, um einen abgeflachten Kanal zu erzeugen, wobei das Aufwärtsmischen und die Synthese auf den abgeflachten Kanal angewendet werden, um einen entsprechenden Wiedergabekanal zu erzeugen.

**27.** Das Verfahren gemäß Anspruch 20, das ferner ein Einstellen eines aufwärtsgemischten Kanals auf der Basis der charakterisierten zeitlichen Hüllkurve umfasst, um einen abgeflachten Kanal zu erzeugen, wobei die Synthese auf den abgeflachten Kanal angewendet wird, um einen entsprechenden Wiedergabekanal zu erzeugen.

**28.** Das Verfahren gemäß Anspruch 20, bei dem die zeitliche Hüllkurve des synthetisierten Signals lediglich für festgelegte Frequenzen eingestellt wird.

**29.** Das Verfahren gemäß Anspruch 28, bei dem die zeitliche Hüllkurve des synthetisierten Signals lediglich für Frequenzen eingestellt wird, die oberhalb einer festgelegten Grenzfrequenz liegen.

**30.** Das Verfahren gemäß Anspruch 20, bei dem zeitliche Hüllkurven individuell für verschiedene Signalteilbänder in dem synthetisierten Signal eingestellt werden.

**31.** Das Verfahren gemäß Anspruch 20, bei dem eine Teilbanddomäne einem QMF entspricht.

**32.** Das Verfahren gemäß Anspruch 20, bei dem die zeitliche Hüllkurve des synthetisierten Signals in einer Zeitdomäne eingestellt wird.

**33.** Das Verfahren gemäß Anspruch 20, das ferner ein Bestimmen umfasst, ob das Einstellen der zeitlichen Hüllkurve des synthetisierten Signals freigegeben oder gesperrt werden soll.

**34.** Das Verfahren gemäß Anspruch 33, bei dem das Bestimmen auf einem Freigeben/Sperren-Flag beruht, das durch einen Audiocodierer erzeugt wird, der den $E$ gesendeten Kanal beziehungsweise die $E$ gesendeten Kanäle erzeugte.

**35.** Das Verfahren gemäß Anspruch 33, bei dem das Bestimmen auf einem Analysieren des $E$ gesendeten Kanals beziehungsweise der $E$ gesendeten Kanäle, um Einschwingvorgänge zu erfassen, beruht, so dass das Einstellen freigegeben wird, falls ein Auftretensfall eines Einschwingvorgangs erfasst wird.

**36.** Das Verfahren gemäß Anspruch 20, das ferner folgende Schritte umfasst:

Charakterisieren einer zeitlichen Hüllkurve eines gesendeten Kanals; und
Bestimmen, ob (1) die charakterisierte zeitliche Hüllkurve, die dem Hüllkurvenhinweiscode entspricht, oder (2) die charakterisierte zeitliche Hüllkurve des gesendeten Signals dazu verwendet werden soll, die zeitliche Hüllkurve des synthetisierten Signals einzustellen.

**37.** Das Verfahren gemäß Anspruch 20, bei dem Leistung innerhalb eines festgelegten Fensters des synthetisierten Signals nach dem Einstellen der zeitlichen Hüllkurve gleich einer Leistung innerhalb eines entsprechenden Fensters des synthetisierten Signals vor dem Einstellen ist.

**38.** Das Verfahren gemäß Anspruch 37, bei dem das festgelegte Fenster einem Synthesefenster entspricht, das einem oder mehreren Nicht-Hüllkurvenhinweiscodes zugeordnet ist.

**39.** Vorrichtung zum Decodieren eines $E$ gesendeten Audiokanals beziehungsweise von $E$ gesendeten Audiokanälen, um $C$ Wiedergabe-Audiokanäle zu erzeugen, wobei $C > E \geq 1$, wobei die Vorrichtung folgende Merkmale umfasst:

eine Einrichtung zum Empfangen von Hinweiscodes, die dem $E$ gesendeten Kanal beziehungsweise den E gesendeten Kanälen entsprechen, wobei die Hinweiscodes einen Hüllkurvenhinweiscode umfassen, der einer charakterisierten zeitlichen Hüllkurve eines Audiokanals entspricht, der dem $E$ gesendeten Kanal beziehungsweise den $E$ gesendeten Kanälen entspricht, wobei die zwei oder mehr Hinweiscodes ferner einen oder mehr von Zwischenkanal-Korrelationscodes (ICC-Codes), Zwischenkanal-Pegeldifferenz-Codes (ICLD-Codes) und Zwischenkanal-Zeitdifferenz-Codes (ICTD-Codes) umfassen, wobei eine dem Hüllenkurvenhinweiscode zugeordnete erste Zeitauflösung feiner ist als eine dem beziehungsweise den anderen Hinweiscode(s) zugeordnete zweite Zeitauflösung;
eine Einrichtung zum Aufwärtsmischen eines oder mehrerer der $E$ gesendeten Kanäle, um einen oder mehr aufwärtsgemischte Kanäle zu erzeugen; und
eine Einrichtung zum Synthetisieren eines oder mehrerer der $C$ Wiedergabekanäle durch Anlegen der Hinweiscodes an den einen oder die mehreren aufwärtsgemischten Kanäle, wobei der Hüllkurvenhinweiscode an einen aufwärtsgemischten Kanal oder ein synthetisiertes Signal angelegt wird, um eine zeitliche Hüllkurve des synthetisierten Signals auf der Basis der charakterisierten zeitlichen Hüllkurve einzustellen, indem Zeitdomänen- oder Teilbanddomänen-Signalabtastwerte unter Verwendung eines Skalierungsfaktors skaliert werden, derart, dass die eingestellte zeitliche Hüllkurve mit der charakterisierten zeitlichen Hüllkurve übereinstimmt.

**40.** Die Vorrichtung gemäß Anspruch 39, wobei:

die Vorrichtung ein System ist, das aus der Gruppe ausgewählt ist, die aus einem digitalen Videoabspielgerät, einem digitalen Audioabspielgerät, einem Computer, einem Satellitenempfänger, einem Kabelempfänger, einem terrestrischen Rundfunkempfänger, einem Unterhaltungssystem und einem Kinosystem besteht; und
das System den Hüllkurvenanalysator, die Codeschätzeinrichtung und den Abwärtsmischer umfasst.

das System den Empfänger, den Aufwärtsmischer, den Synthetisierer und die Hüllkurveneinstelleinrichtung umfasst.

**41.** Ein Computerprogrammprodukt, das einen Programmcode aufweist und bei dem, wenn der Programmcode durch eine Maschine ausgeführt wird, die Maschine ein Verfahren zum Decodieren gemäß Anspruch 20 implementiert.

**Revendications**

**1.** Procédé de codage de canaux audio, le procédé comprenant:

générer deux ou plusieurs codes repères pour un ou plusieurs canaux audio, où au moins un code de sélection est un code repère d'enveloppe généré en caractérisant une enveloppe temporelle dans l'un des un ou plusieurs canaux audio, où les deux ou plusieurs codes repères comprennent par ailleurs un ou plusieurs des codes de corrélation entre canaux (ICC), des codes de différence de niveau entre canaux (ICLD) et des codes de différence de temps entre canaux (ICTD), où une première résolution dans le temps associée au code repère d'enveloppe est plus fine qu'une deuxième résolution dans le temps associée à l'autre ou aux autres codes repères, et où l'enveloppe temporelle est **caractérisée** pour le canal audio correspondant dans un domaine du temps ou individuellement pour différentes sous-bandes de signal du canal audio correspondant dans un domaine de sous-bande; et

transmettre les deux ou plusieurs codes repères.

**2.** Procédé selon la revendication 1, comprenant par ailleurs la transmission de $E$ canaux audio transmis correspondant aux un ou plusieurs canaux audio, où $E \geq 1$.

**3.** Procédé selon la revendication 2, dans lequel:

les un ou plusieurs canaux audio comprennent C canaux audio d'entrée, où C>E; et
les $C$ canaux d'entrée sont mélangés vers le bas, pour générer les $E$ canaux transmis.

**4.** Procédé selon la revendication 1, dans lequel deux ou plusieurs codes de repère sont transmis pour permettre qu'un décodeur effectue la mise en forme de l'enveloppe pendant le décodage des E canal ou canaux transmis sur base des deux ou plusieurs codes de repère, dans lequel le ou les $E$ canaux audio transmis correspondent aux un ou plusieurs canaux audio, où $E \geq 1$.

**5.** Procédé selon la revendication 4, dans lequel la mise en forme de l'enveloppe ajuste une enveloppe temporelle d'un signal synthétisé généré par le décodeur de manière à s'adapter à l'enveloppe temporelle **caractérisée**.

**6.** Procédé selon la revendication 1, dans lequel l'enveloppe temporelle n'est **caractérisée que** pour des fréquences spécifiées du canal audio correspondant.

**7.** Procédé selon la revendication 1, dans lequel l'enveloppe temporelle n'est **caractérisée que** pour des fréquences du canal audio correspondant au-dessus d'une fréquence de coupure spécifiée.

**8.** Procédé selon la revendication 1, dans lequel le domaine de sous-bande correspond à un filtre miroir en quadrature (QMF).

**9.** Procédé selon la revendication 1, comprenant par ailleurs la détermination de s'il y a lieu d'activer ou de désactiver la caractérisation.

**10.** Procédé selon la revendication 9, comprenant par ailleurs la génération et la transmission d'un drapeau activer/désactiver sur base de la détermination, pour donner instruction à un décodeur de mettre en oeuvre ou non la mise en forme de l'enveloppe pendant le décodage des $E$ canal ou canaux transmis correspondant aux un ou plusieurs canaux audio, où $E \geq 1$.

**11.** Procédé selon la revendication 9, dans lequel la détermination est basée sur l'analyse d'un canal audio pour détecter des transitoires dans le canal audio de sorte que la caractérisation soit activée s'il est détecté l'occurrence d'un transitoire.

**12.** Procédé selon la revendication 1, dans lequel l'étape de génération du code de repère d'enveloppe comporte le fait d'élever au carré (1006) ou de former une amplitude et de filtrer passe-bas (1008) des échantillons de signal du canal audio ou de signaux de sous-bande du canal audio, pour caractériser l'enveloppe temporelle.

**13.** Procédé selon la revendication 1 ou 12, dans lequel l'étape de génération comprend par ailleurs une étape de paramétrisation, de quantification et de codage d'une enveloppe temporelle estimée.

**14.** Appareil de codage de canaux audio, l'appareil comprenant:

un moyen destiné à générer deux ou plusieurs codes de repère pour un ou plusieurs canaux audio, où au moins un code de repère est un code de repère d'enveloppe généré en caractérisant une enveloppe temporelle dans l'un des un ou plusieurs canaux audio, où les deux ou plusieurs codes de repère comprennent par ailleurs un ou plusieurs parmi les codes de corrélation entre canaux (ICC), les codes de différence de niveau entre canaux (ICLD) et les codes de différence de temps entre canaux (ICTD), où une première résolution dans le temps associée au code de repère d'enveloppe est plus fine qu'une deuxième résolution dans le temps associée à l'autre ou aux autres codes de repère, et où l'enveloppe temporelle est **caractérisée** pour le canal audio correspondant dans un domaine du temps ou individuellement pour différentes sous-bandes de signal du canal audio correspondant dans un domaine de sous-bande; et
un moyen destiné à transmettre des informations sur les deux ou plusieurs codes de repère.

**15.** Appareil selon la revendication 14,
dans lequel l'appareil est opérationnel pour coder C canaux audio d'entrée pour générer $E$ canal ou canaux audio transmis,
dans lequel le moyen destiné à générer comprend un analyseur d'enveloppe adapté pour caractériser l'enveloppe temporelle d'entrée d'au moins l'un des $C$ canaux d'entrée,
dans lequel le moyen destiné à générer comprend par ailleurs un estimateur de code adapté pour générer les codes de repère pour deux ou plusieurs des $C$ canaux d'entrée, et
dans lequel l'appareil comprend par ailleurs un mélangeur descendant adapté pour mélanger vers le bas les $C$ canaux d'entrée pour générer les E canal ou canaux transmis, où $C>E\geq 1$,
dans lequel le moyen destiné à transmettre est adapté pour transmettre les informations sur les deux ou plusieurs codes de repère pour permettre qu'un décodeur effectue la synthèse et la mise en forme de l'enveloppe pendant le décodage des $E$ canal ou canaux transmis.

**16.** Appareil selon la revendication 15, dans lequel:

l'appareil est un système sélectionné parmi le groupe composé d'un enregistreur vidéo numérique, d'un enregistreur audio numérique, d'un ordinateur, d'un émetteur par satellite, d'un émetteur par câble, d'un émetteur de diffusion terrestre, d'un système de divertissement à domicile, et d'un système de cinéma; et
le système comprend l'analyseur d'enveloppe, l'estimateur de code et le mélangeur descendant.

**17.** Programme d'ordinateur, ayant un code de programme, dans lequel, lorsque le code de programme est exécuté par une machine, la machine met en oeuvre un procédé selon la revendication 1.

**18.** Train binaire audio codé présentant:

deux ou plusieurs codes de repère générés pour un ou plusieurs canaux audio, où au moins un code de repère est un code de repère d'enveloppe généré en caractérisant une enveloppe temporelle dans l'un des un ou plusieurs canaux audio, où les deux ou plusieurs codes de repère comprennent par ailleurs un ou plusieurs parmi les codes de corrélation entre canaux (ICC), les codes de différence de niveau entre canaux (ICLD) et les codes de différence de temps entre canaux (ICTD), où une première résolution dans le temps associée au code de repère d'enveloppe est plus fine qu'une deuxième résolution dans le temps associée à l'autre ou aux autres codes de repère, et où l'enveloppe temporelle est **caractérisée** pour le canal audio correspondant dans un domaine du temps ou individuellement pour différentes sous-bandes de signal du canal audio correspondant dans un domaine de sous-bande; et
les deux ou plusieurs codes de repère et les $E$ canal ou canaux audio transmis correspondant aux un ou plusieurs canaux audio, où $E\geq1$, sont codés pour obtenir le train binaire audio codé.

**19.** Train binaire audio codé selon la revendication 18, comprenant par ailleurs E canal ou canaux transmis audio, dans lequel

les *E* canal ou canaux audio transmis correspondent aux un ou plusieurs canaux audio.

**20.** Procédé de décodage de *E* canal ou canaux audio transmis pour générer C canaux audio de reproduction, où *C>E≥*1*,* le procédé comprenant:

recevoir les codes de repère correspondant aux E canal ou canaux transmis, où les codes de repère comprennent un code de repère d'enveloppe correspondant à une enveloppe temporelle **caractérisée** d'un canal audio correspondant aux *E* canal ou canaux transmis, où les deux ou plusieurs codes de repère comprennent par ailleurs un ou plusieurs parmi les codes de corrélation entre canaux (ICC), les codes de différence de niveau entre canaux (ICLD) et les codes de différence de temps entre canaux (ICTD), où une première résolution dans le temps associée au code de repère d'enveloppe est plus fine qu'une deuxième résolution dans le temps associée à l'autre ou aux autres codes de repère;

mélanger vers le haut un ou plusieurs des *E* canal ou canaux transmis pour générer un ou plusieurs canaux mélangés vers le haut; et

synthétiser un ou plusieurs des *C* canaux de reproduction en appliquant les codes de repère aux un ou plusieurs canaux mélangés vers le haut, où le code de repère d'enveloppe est appliqué à un canal mélangé vers le haut ou un signal synthétisé pour ajuster une enveloppe temporelle du signal synthétisé sur base de l'enveloppe temporelle **caractérisée en** modulant des échantillons de signal dans le domaine du temps ou dans le domaine de sous-bande à l'aide d'un facteur de modulation de sorte que l'enveloppe temporelle ajustée coïncide avec l'enveloppe temporelle **caractérisée**.

**21.** Procédé selon la revendication 20, dans lequel le code de repère d'enveloppe correspond à une enveloppe temporelle **caractérisée** dans un canal d'entrée original utilisé pour générer les *E* canal ou canaux transmis.

**22.** Procédé selon la revendication 21, dans lequel la synthèse comprend une synthèse ICC à réverbération tardive.

**23.** Procédé selon la revendication 21, dans lequel l'enveloppe temporelle du signal synthétisé est ajustée avant la synthèse ICLD.

**24.** Procédé selon la revendication 20, dans lequel:

l'enveloppe temporelle du signal synthétisé est **caractérisée** ; et

l'enveloppe temporelle du signal synthétisé est ajustée sur base de l'enveloppe temporelle **caractérisée** correspondant au code de repère d'enveloppe et à l'enveloppe temporelle **caractérisée** du signal synthétisé.

**25.** Procédé selon la revendication 24, dans lequel:

une fonction de modulation est générée sur base de l'enveloppe temporelle **caractérisée** correspondant au code de repère d'enveloppe et à l'enveloppe temporelle **caractérisée** du signal synthétisé; et

la fonction de modulation est appliquée au signal synthétisé.

**26.** Procédé selon la revendication 20, comprenant par ailleurs le fait d'ajuster un canal transmis sur base de l'enveloppe temporelle

**caractérisée** pour générer un canal aplani, où le mélange ascendant et la synthèse sont appliqués au canal aplani pour générer un canal de reproduction correspondant.

**27.** Procédé selon la revendication 20, comprenant par ailleurs le fait d'ajuster le canal mélangé vers le haut sur base de l'enveloppe temporelle **caractérisée** pour générer un canal aplani, où la synthèse est appliquée au canal aplani pour générer un canal de reproduction correspondant.

**28.** Procédé selon la revendication 20, dans lequel l'enveloppe temporelle du signal synthétisé n'est ajustée que pour des fréquences spécifiées.

**29.** Procédé selon la revendication 28, dans lequel l'enveloppe temporelle du signal synthétisé n'est ajustée que pour des fréquences au-dessus d'une fréquence de coupure spécifiée.

**30.** Procédé selon la revendication 20, dans lequel les enveloppes temporelles sont ajustées individuellement pour différentes sous-bandes de signal dans le signal synthétisé.

31. Procédé selon la revendication 20, dans lequel un domaine de sous-bande correspond à un QMF.

32. Procédé selon la revendication 20, dans lequel l'enveloppe temporelle du signal synthétisé est ajustée dans un domaine du temps.

33. Procédé selon la revendication 20, comprenant par ailleurs le fait de déterminer s'il y a lieu d'activer ou de désactiver l'ajustage de l'enveloppe temporelle du signal synthétisé.

34. Procédé selon la revendication 33, dans lequel la détermination est basée sur un drapeau activation/désactivation généré par un codeur audio qui a généré les E canal ou canaux transmis.

35. Procédé selon la revendication 33, dans lequel la détermination est basée sur l'analyse des *E* canal ou canaux transmis, pour détecter les transitoires de sorte que l'ajustage soit activé s'il est détecté l'occurrence d'un transitoire.

36. Procédé selon la revendication 20, comprenant par ailleurs:
caractériser une enveloppe temporelle d'un canal transmis; et
déterminer s'il y a lieu d'utiliser (1) l'enveloppe temporelle **caractérisée** correspondant au code de repère d'enveloppe ou (2) l'enveloppe temporelle **caractérisée** du canal transmis pour ajuster l'enveloppe temporelle du signal synthétisé.

37. Procédé selon la revendication 20, dans lequel l'énergie dans une fenêtre spécifiée du signal synthétisé après ajustage de l'enveloppe temporelle est égale à l'énergie dans une fenêtre correspondante du signal synthétisé avant ajustage.

38. Procédé selon la revendication 37, dans lequel la fenêtre spécifiée correspond à une fenêtre de synthèse associée à un ou plusieurs codes de repère non d'enveloppe.

39. Appareil de décodage de *E* canal ou canaux audio transmis pour générer *C* canaux audio de reproduction, où *C>E≥*1*,* l'appareil comprenant:

   un moyen destiné à recevoir les codes de repère correspondant aux *E* canal ou canaux transmis, où les codes de repère comprennent un code de repère d'enveloppe correspondant à une enveloppe temporelle **caractérisée** d'un canal audio correspondant aux *E* canal ou canaux transmis, où les deux ou plusieurs codes de repère comprennent par ailleurs un ou plusieurs parmi les codes de corrélation entre canaux (ICC), les codes de différence de niveau entre canaux (ICLD) et les codes de différence de temps entre canaux (ICTD), où une première résolution dans le temps associée au code de repère d'enveloppe est plus fine qu'une deuxième résolution dans le temps associée à l'autre ou aux autres codes de repère;
   un moyen destiné à mélanger vers le haut un ou plusieurs des *E* canaux transmis pour générer un ou plusieurs canaux mélangés vers le haut; et
   un moyen destiné à synthétiser un ou plusieurs des *C* canaux de reproduction en appliquant les codes de repère aux un ou plusieurs canaux mélangés vers le haut, où le code de repère d'enveloppe est appliqué à un canal mélangé vers le haut ou un signal synthétisé pour ajuster une enveloppe temporelle du signal synthétisé sur base de l'enveloppe temporelle **caractérisée en** modulant des échantillons de signal dans le domaine du temps ou dans le domaine de sous-bande à l'aide d'un facteur de modulation de sorte que l'enveloppe temporelle ajustée coïncide avec l'enveloppe temporelle **caractérisée**.

40. Appareil selon la revendication 39, dans lequel:

   l'appareil est un système sélectionné parmi le groupe composé d'un enregistreur vidéo numérique, d'un enregistreur audio numérique, d'un ordinateur, d'un émetteur par satellite, d'un émetteur par câble, d'un émetteur de diffusion terrestre, d'un système de divertissement à domicile, et d'un système de cinéma; et
   le système comprend le récepteur, le mélangeur ascendant, le synthétiseur et l'ajusteur d'enveloppe.

41. Programme d'ordinateur présentant un code de programme,
dans lequel, lorsque le code de programme est exécuté par une machine, la machine met en oeuvre un procédé de décodage selon la revendication 20.

# FIG. 1
## (PRIOR ART)

100

MONO
SOURCE
SIGNAL $\rightarrow$ BINAURAL SIGNAL SYNTHESIZER $\rightarrow$ LEFT AUDIO SIGNAL

$\rightarrow$ RIGHT AUDIO SIGNAL

SPATIAL PARAMETERS FOR SOURCE

# FIG. 2
200

202

ENCODER   206

DECODER   204

$x_1(n)$
$x_2(n)$
$x_C(n)$

DOWNMIX C-TO-E

$y_1(n)$
$\vdots$
$y_E(n)$

ICTD, ICLD, ICC SYNTHESIS

$\hat{x}_1(n)$
$\hat{x}_2(n)$
$\hat{x}_C(n)$

ICTD, ICLD, ICC ESTIMATION

SIDE INFORMATION

(TP DATA)

208

27

## FIG. 3

$$300$$

$x_1(n) \rightarrow$ FB $\rightarrow \tilde{x}_1(k) \rightarrow$ DOWN-MIXING $\rightarrow \hat{y}_1(k) \rightarrow \otimes \rightarrow \tilde{y}_1(k) \rightarrow$ IFB $\rightarrow y_1(n)$

302 304 $e_1(k)$ 310 308

$x_2(n) \rightarrow$ FB $\rightarrow \tilde{x}_2(k)$ ... $\hat{y}_2(k) \rightarrow \otimes \rightarrow \tilde{y}_2(k) \rightarrow$ IFB $\rightarrow y_2(n)$

$e_2(k)$

$x_C(n) \rightarrow$ FB $\rightarrow \tilde{x}_C(k)$ ... $\hat{y}_E(k) \rightarrow \otimes \rightarrow \tilde{y}_E(k) \rightarrow$ IFB $\rightarrow y_E(n)$

302 $e_E(k)$ 310 308

306

FIG. 4

## FIG. 5

502

$x_1(n)$ → FB → $\tilde{x}_1(k)$

$x_2(n)$ → FB → $\tilde{x}_2(k)$

$x_C(n)$ → FB → $\tilde{x}_C(n)$

504

ICTD, ICLD, ICC ESTIMATION

208

→ SPATIAL CUES

## FIG. 6

LEFT    CENTER    RIGHT

3

1    2

$\tau_{15}(k)$

$\Delta L_{15}(k)$

REAR LEFT    4    5    REAR RIGHT

## FIG. 7A

LEFT   CENTER   RIGHT

REAR LEFT   4

$c_{15}(k)$

5   REAR RIGHT

## FIG. 7B

LEFT   CENTER   RIGHT

1   3   2

$c_{12}(k)$

$c_{34}(k-1)$

REAR LEFT   4

5   REAR RIGHT

FIG. 8

## FIG. 9

## FIG. 10A

## FIG. 10B

FIG. 11A

FIG. 11B

## FIG. 12A

TEMPORAL PROCESSING ANALYSIS (TPA)

## FIG. 12B

TEMPORAL PROCESSING (TP)

*FIG. 13A*

*FIG. 13B*

FIG. 14A

FIG. 14B

FIG. 15

EP 1 803 117 B1

FIG. 16

EP 1 803 117 B1

FIG. 17A

ENVELOPE
EXTRACTION (TPA)

LPC ANALYSIS

(e.g. AUTOCORRELATION
METHOD)

SPECTRAL
COEFFICIENTS

LPC
COEFFICIENTS

FIG. 17B

INVERSE ENVELOPE
ADJUSTMENT (ITP)

PREDICTOR

SPECTRAL
COEFFICIENTS

SPECTRAL
COEFFICIENTS

LPC
COEFFICIENTS

FIG. 17C

ENVELOPE
ADJUSTMENT (TP)

PREDICTOR

SPECTRAL
COEFFICIENTS

SPECTRAL
COEFFICIENTS

LPC
COEFFICIENTS

FIG. 18A

FIG. 18B

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 20030026441 A
- US 20030035553 A
- US 20030219130 A
- US 20030236583 A
- US 20090180579 A
- US 20050058304 A
- US 20050157883 A
- US 20060085200 A
- US 5812971 A, HERRE

### Non-patent literature cited in the description

- **F. BAUMGARTE ; C. FALLER.** Binaural Cue Coding - Part I: Psychoacoustic fundamentals and design principles. *IEEE Trans. on Speech and Audio Proc.,* November 2003, vol. 11 (6
- **C. FALLER ; F. BAUMGARTE.** Binaural Cue Coding - Part II: Schemes and applications. *IEEE Trans. on Speech and Audio Proc.,* November 2003, vol. 11 (6
- **C. FALLER.** Coding of spatial audio compatible with different playback formats. *Preprint 17th Conv. Aud. Eng. Soc.,* October 2004
- **J. BLAUERT.** The Psychophysics of Human Sound Localization. MIT Press, 1983
- **D.R. BEGAULT.** 3-D Sound for Virtual Reality and Multimedia. Academic Press, 1994
- **C. FALLER.** Parametric Coding of Spatial Audio. *Proceedings of the 7th International Conference on Digital Audio Effect,* 05 October 2004
- **C. FALLER.** Parametric multi-channel audio coding: Synthesis of coherence cues. *IEEE Trans. on Speech and Audio Proc.,* 2003
- **E. SCHUIJERS ; W. OOMEN ; B. DEN BRINKER ; J. BREEBAART.** Advances in parametric coding for high-quality audio. *Preprint 114th Conv. Aud. Eng. Soc.,* March 2003
- **J. ENGDEGARD ; H. PURNHAGEN ; J. RODEN ; L. LILJERYD.** Synthetic ambience in parametric stereo coding. *Preprint 117th Conv. Aud. Eng. Soc.,* May 2004